# EUROPEAN PATENT APPLICATION

(11) **EP 3 595 023 A1**
(43) Date of publication of application: **15.01.2020**
(21) Application number: 18763806.9
(22) Date of filing: 01.03.2018
(51) Int. Cl.: H01L 35/32, H01L 35/30, H01L 35/34

(54) **THERMOELECTRIC CONVERSION MODULE AND METHOD FOR MANUFACTURING SAME**

(30) Priority: 08.03.2017 JP 2017043487; 28.08.2017 JP 2017163484
(71) Applicant: Mitsubishi Materials Corporation, Chiyoda-ku Tokyo 100-8117 (JP)
(72) Inventor: ARAI, Koya, Saitama-shi Saitama 330-8508 (JP); KOMASAKI, Masahito, Saitama-shi Saitama 330-8508 (JP)
(74) Representative: Hoffmann Eitle
(86) International application number: PCT/JP2018/007801
(87) International publication number: WO 2018/163958

(57) **Abstract**

A thermoelectric conversion module has:
a plurality of thermoelectric conversion elements including a P-type thermoelectric conversion element and an N-type thermoelectric conversion element having differing linear expansion coefficients; and a first wiring board arranged at one end side of the plurality of thermoelectric conversion elements, the first wiring board having: first wiring layers in which the adjacent P-type thermoelectric conversion element and N-type thermoelectric conversion element are joined; and first ceramic layers joined to the surface of the first wiring layers which are opposite to a joined surface to which the P-type thermoelectric conversion elements and the N-type thermoelectric conversion elements are joined, and multiply separated, the first ceramic layers being separated between any pair of the P-type thermoelectric conversion element and the N-type thermoelectric conversion element.

## Description

### BACKGROUND OF THE INVENTION

### Technical Field

The present invention relates to a thermoelectric conversion module in which a P-type thermoelectric conversion element and an N-type thermoelectric conversion element are arranged in series and a manufacturing method thereof.

Priority is claimed on Japanese Patent Application No. 2017-43487, filed March 8, 2017 and Japanese Patent Application No. 2017-163484 filed August 28, 2017, the content of which is incorporated herein by reference.

### Background Art

A thermoelectric conversion module ordinarily has a structure in which between a pair of wiring boards (insulation boards), each pair of a P-type and an N-type thermoelectric conversion elements are arranged in order of the P-type, the N-type, the P-type, and the N-type alternately, and electrically connected in series. The thermoelectric conversion module, in which both ends of wiring are connected to a direct current source, moves heat in the thermoelectric conversion elements by the Peltier effect (in the P-type moving in a same direction as a current, or in the N-type moving in an opposite direction to the current); or the thermoelectric conversion module generates electromotive force by the Seebeck effect, by adding temperature difference between the wiring boards: it is possible to be used for cooling, heating, or generating electrical energy.

The thermoelectric conversion module has higher efficiency when operated in higher temperature, so that a lot of thermoelectric conversion modules are developed in a high-temperature type. Resin cannot be used for material of the insulation board in thermoelectric conversion modules used in higher than middle-or-high temperature (300°C); ceramic is ordinarily used for the insulation board.

Among types of ceramic, there is material having both insulation performance and heat-transfer performance, such as aluminum nitride, for example. However, ceramic is hard material with high rigidity; so that the rigid body changes a difference of linear expansion between the thermoelectric conversion elements into thermal stress. That is to say, in a case in which materials having different coefficients of linear expansion are used as the thermoelectric conversion materials in both the thermoelectric conversion elements, which are the P-type thermoelectric conversion element and the N-type thermoelectric conversion element; if the thermoelectric conversion module is installed on a heat source, the thermoelectric conversion elements are fixed by the ceramic board, and cannot follow variations of shapes. Accordingly, compressive stress is generated in the thermoelectric conversion element having larger coefficient of linear expansion: and tensile stress is generated in the thermoelectric conversion element having smaller coefficient of linear expansion.

In a case in which thermal stress is generated by a difference of thermal expansion, the thermoelectric conversion element may be peeled off from a wiring part of the wiring board, or may crack. In this case, there may be cases in which the thermoelectric conversion module cannot perform because the electric current cannot flow or electrical conductivity is deteriorated; and electric power generation may be remarkably reduced even it does not go defective operation.

Therefore, in Patent Documents 1 to 3 for example, it is attempt to reduce the thermal stress resulting from the difference of thermal expansion by adding flexibility on wirings, by using so-called foamed metals (porous metal materials, porous metal members) or aggregate of metal fiber as the wirings (electrodes) connecting a plurality of thermoelectric conversion elements (thermoelectric semiconductor materials, thermoelectric conversion semiconductor).

### Citation List

### Patent Literature

Patent Document 1: Japanese Unexamined Patent Application, First Publication No. 2007-103580
Patent Document 2: International Patent Publication No. 2010/010783
Patent Document 3: Japanese Granted Patent Publication, No. 5703871

### SUMMARY OF INVENTION

### Technical Problem

In Patent Documents 1 to 3, aggregates of foamed metal or metal fiber are used for the wiring; structures in which electric current flows on these members are used. Accordingly, inner resistance (thermal resistance and electrical resistance) of the wiring are significantly increased, so that output of the thermoelectric conversion module may be significantly reduced.

The present invention is achieved in consideration of the above circumstances, and has an object to provide a thermoelectric conversion module which can prevent breakage resulting from the difference of thermal expansion between thermoelectric conversion elements and has excellent joining reliability, thermal conductivity and electrical conductivity and a manufacturing method thereof.

### Solution to Problem

A thermoelectric conversion module of the present invention has: multiple thermoelectric conversion elements including P-type thermoelectric conversion elements and N-type thermoelectric conversion elements which are different in coefficient of linear expansion; and a first wiring board disposed at one end side of the multiple thermoelectric conversion elements: the first wiring board has first wiring layers on which the P-type thermoelectric conversion elements and the N-type thermoelectric conversion elements which are adjacent are joined and first ceramic layers which are separated into multiple segments and joined on surfaces of the first wiring layers opposite to surface on which the P-type thermoelectric conversion elements and the N-type thermoelectric conversion elements are joined: the first ceramic layers are separated between any one of the thermoelectric conversion elements and any one of the N-type thermoelectric conversion elements.

In the first wiring board on which the one end side of the thermoelectric conversion elements are joined, the P-type thermoelectric conversion elements and the N-type thermoelectric conversion elements which are adjacent are joined on the first wiring layers which construct the first wiring board; and the P-type thermoelectric conversion elements and the N-type thermoelectric conversion elements are electrically connected by the first wiring layers. On the other hand, the first ceramic layers joined on the first wiring layers are separated between any one of the P-type thermoelectric conversion elements and any one of the N-type thermoelectric conversion elements among the thermoelectric conversion elements.

As above, since the rigid first ceramic layers are divided between any one of the P-type thermoelectric conversion elements and any one of the N-type thermoelectric conversion elements and formed with multiple pieces, the first ceramic layers do not restrain the other-side deformation by thermal expansion between these P-type thermoelectric conversion elements and the N-type thermoelectric conversion elements. Accordingly, it is possible to restrain thermal stress generated in the thermoelectric conversion elements by the difference of thermal expansion of the thermoelectric conversion elements, and it is possible to prevent the thermoelectric conversion elements from peeling off from the first wiring board (the first wiring layers) and the thermoelectric conversion elements from cracking. Accordingly, it is possible to favorably maintain the electrical connection between the thermoelectric conversion elements which are connected by the first wiring layers, and it is possible to favorably maintain joining reliability, thermal conductivity and electrical conductivity of the thermoelectric conversion module.

Moreover, the first wiring board is provided with the first ceramic layers. Therefore, when the thermoelectric conversion module is installed on a heat source or the like, it is possible to prevent the first wiring layers from being in contact with the heat source or the like by the first ceramic layers. Accordingly, electrical connection (a leak) between the first wiring layers and the heat source or the like can be reliably prevented and an insulation state can be favorably maintained. In addition, voltage is low in the thermoelectric conversion elements: therefore, if the first ceramic layers which are insulation boards are separated between the P-type thermoelectric conversion elements and the N-type thermoelectric conversion elements which are adjacent, the electrical leak would not arise as long as the first wiring layers are not physically in contact with the heat source or the like even if the first ceramic layers are not joined on whole surfaces of the first wiring layers.

As a preferred aspect of the thermoelectric conversion module of the present invention, it is preferable that the first wiring layers be formed with spanning the first ceramic layers.

In this case, a difference of thermal expansion between the P-type thermoelectric conversion elements and the N-type thermoelectric conversion elements which are adjacent can be absorbed at a dimensional change by deformation of connecting parts of the first wiring layers connecting the thermoelectric conversion elements. Accordingly, thermal stress generated in the thermoelectric conversion elements by the difference of thermal expansion between the thermoelectric conversion elements can be reduced.

As a preferred aspect of the thermoelectric conversion module of the present invention, it is preferable that the first ceramic layers be formed independently on the every thermoelectric conversion element.

In this case, the first ceramic layers structuring the first wiring board are formed independently on the respective thermoelectric conversion elements, the rigid first ceramic layers are separated between the thermoelectric conversion elements. Therefore, the deformation of the thermoelectric elements would not be restrained by the first ceramic layers. Moreover, regarding the difference of thermal expansion between the P-type thermoelectric conversion elements and the N-type thermoelectric conversion elements which are adjacent, the dimension change can be absorbed by deformation of connecting parts of the first wiring layers connecting the thermoelectric conversion elements. Accordingly, thermal stress generated in the thermoelectric conversion elements by the difference of thermal expansion can be prevented from arising.

As a preferred aspect of the thermoelectric conversion module of the present invention, it is preferable the first wiring layers be silver, aluminum, copper or nickel. Silver, aluminum, copper or nickel include alloys which include them as main ingredients. Preferably, the first wiring layers be aluminum with purity 99.99% by mass, or copper with purity 99.9% by mass.

High-purity aluminum (Al) and copper (Cu) are easy to be elastically deformed and plastically deformed. Moreover, aluminum and copper are excellent in thermal conductivity and electrical conductivity. Accordingly, by using soft material such as pure aluminum, pure copper or the like having high purity for the first wiring layers, it is possible to easily deform the first wiring layers along with the thermal expansion of the thermoelectric conversion elements so as to follow them. Therefore, it is possible to further improve an absorbing effect of thermal stress owing to the difference of thermal expansion between the thermoelectric conversion elements. Moreover, since aluminum and copper are inexpensive comparing with silver, the thermoelectric conversion module can be produced at low cost. Moreover, by forming the first wiring layers from aluminum or copper, it is possible to favorably maintain the thermal conductivity and the electrical conductivity between the thermoelectric conversion elements which are connected by the first wiring layers.

By forming the first wiring layers from silver (Ag), for example in a case in which the first wiring board having the first wiring layers is disposed at a higher temperature side in the thermoelectric conversion module, it is possible to improve heat resistance and resistance to oxidation, and it is possible to favorably maintain the thermal conductivity and the electrical conductivity.

Nickel (Ni) is inferior in the resistance to oxidation comparing with aluminum and silver though, has relatively good heat resistance. Moreover, nickel is inexpensive comparing with silver and has relatively good bondability to elements. Accordingly, by forming the first wiring layers from nickel, it is possible to structure the excellent thermoelectric conversion module in balance of performance and costs.

As a preferred aspect of the thermoelectric conversion module of the present invention, it is preferable that the first wiring board have a plurality of the first wiring layers and first heat-transmission metal layers joined on surfaces of the first ceramic layers opposite to surfaces on which the first wiring layers are joined: and the first heat-transmission metal layers be formed with spanning the adjacent two first wiring layers and formed with spanning the adjacent two first ceramic layers.

Also in the first wiring board having the multiple first wiring layers, the first ceramic layers are connected by the first heat-transmission metal layers: so the first wiring layers can be treated integrally and handling property of the first wiring board can be improved. Moreover, the first ceramic layers are connected to each other only by either one of the first wiring layers or the first heat-transmission metal layers: the first wiring layers and the first heat-transmission metal layers are deformed with and follow easily the thermal expansion of the thermoelectric conversion elements. Accordingly, it is possible to restrain arising of thermal stress generated in the thermoelectric conversion elements owing to the difference of thermal expansion of the thermoelectric conversion elements: so it is possible to prevent the thermoelectric conversion elements from peeling off from the first wiring board (the first wiring layers) and the thermoelectric conversion elements from cracking.

Moreover, by providing the first heat-transmission metal layers on the first wiring board, when the thermoelectric conversion module is installed on the heat source or the like, it is possible to improve adhesiveness between the heat source or the like and the thermoelectric conversion module by the first heat-transmission metal layers and improve the thermal conductivity. Accordingly, it is possible to improve the thermoelectric conversion performance (the power generation efficiency) of the thermoelectric conversion module.

As a preferred aspect of the thermoelectric conversion module of the present invention, it is preferable that the first heat-transmission metal layers be aluminum or copper; preferably, aluminum with purity 99.99% by mass or higher, or copper with purity 99.9% by mass or higher.

Also for the first heat-transmission metal layers by using soft material such as pure aluminum, pure copper or the like with high purity as in the first wiring layers, it is possible for the first heat-transmission metal layers to be deformed easily with and to follow the thermal expansion of the thermoelectric conversion elements. Accordingly, it is possible to further improve the effect of defusing the thermal stress owing to the difference of thermal expansion of the thermoelectric conversion elements. Moreover, by forming the first heat-transmission metal layers from aluminum or copper, it is possible to favorably maintain the thermal conductivity between the thermoelectric conversion module and the heat source or the like, and it is possible to favorably maintain the thermoelectric conversion performance.

As a preferred aspect of the thermoelectric conversion module of the present invention, it is preferable to have a second wiring board disposed at the other end side of the thermoelectric conversion elements: and that the P-type thermoelectric conversion elements and the N-type thermoelectric conversion elements be electrically connected in series via the first wiring board and the second wiring board which are disposed with facing to each other.

The first ceramic layers structuring at least the first wiring board between the first wiring board and the second wiring board which are disposed facing to each other are separated between any one of the P-type thermoelectric conversion elements and any one of the N-type thermoelectric conversion elements. Therefore, between these P-type thermoelectric conversion elements and N-type thermoelectric conversion elements, the deformation with the thermal expansion would not be restrained by the first ceramic layers which are joined on the other side. Moreover, the difference of thermal expansion between the P-type thermoelectric conversion elements and the N-type thermoelectric conversion elements can be absorbed in the dimension change by deformation of the connecting parts of the first wiring layers and the first heat-transmission metal layers connecting the thermoelectric conversion elements. Therefore, it is possible to restrain the generation of thermal stress generated in the thermoelectric conversion elements by the difference of thermal expansion of the thermoelectric conversion elements. Accordingly, it is possible to favorably maintain the electrical connection between the thermoelectric conversion elements connected by the first wiring layers and it is possible to favorably maintain the bonding reliability, the thermal conductivity and the electrical conductivity of the thermoelectric conversion module.

As a preferred aspect of the thermoelectric conversion module of the present invention, it is preferable that the second wiring board include second wiring layers on which the P-type thermoelectric conversion elements and the N-type thermoelectric conversion elements which are adjacent are joined; and second ceramic layers which are plurally separated and joined on surfaces of the second wiring layers opposite to surfaces on which the P-type thermoelectric conversion elements and the N-type thermoelectric conversion elements are joined: and the second ceramic layers be separated between any one of the P-type thermoelectric conversion elements and any one of the N-type thermoelectric conversion elements.

It is preferable that the second wiring layers be formed with spanning the second ceramic layers. The second ceramic layers are preferably formed independently on the respective thermoelectric conversion elements. The second wiring layers are preferably silver, aluminum, copper, or nickel.

It is preferable that the second wiring board have the second wiring layers and second heat-transmission metal layers joined on surfaces of the second ceramic layers opposite to surfaces on which the second wiring layers are joined; and that the second heat-transmission metal layers be formed with spanning the two adjacent second wiring layers and formed with spanning the two adjacent second ceramic layers. It is preferable that the second heat-transmission metal layers be aluminum or copper.

Also in the second wiring board disposed with facing to the first wiring board, the second wiring layers on which the adjacent P-type thermoelectric conversion element and N-type thermoelectric conversion element are joined are formed with spanning the plurally separated second ceramic layers; and the second ceramic layers are separated between the P-type thermoelectric conversion elements and the N-type thermoelectric conversion elements: the deformation owing to the thermal expansion between the P-type thermoelectric conversion elements and the N-type thermoelectric conversion elements joined on the second wiring layers are not restricted by the second ceramic layers at the other-side members. Moreover, the difference of thermal expansion between the adjacent P-type thermoelectric conversion element and N-type thermoelectric conversion element can be absorbed at dimension change by the deformation of the connecting parts of the second wiring layers connecting the two thermoelectric conversion elements: so it is possible to reduce thermal stress generated in the thermoelectric conversion elements from arising owing to the difference of the thermal expansion between the thermoelectric conversion elements.

As described above, in both the first wiring board and the second wiring board which are disposed with facing to each other, the dimension change arising from the difference of thermal expansion in the thermoelectric conversion elements can be absorbed, so that it is possible to favorably maintain the electrical connection between the two thermoelectric conversion elements which are connected by the first wiring layers and the second wiring layers, and it is possible to favorably maintain the bonding reliability, the thermal conductivity and the electrical conductivity of the thermoelectric conversion module.

A method of manufacturing a thermoelectric conversion module of the present invention includes: a step of forming a scribe line on a ceramic panel for splitting the ceramic panel into multiple first ceramic layers;
a step of forming a metal layer after the step of forming the scribe line,
forming a first wiring layer on one surface of the ceramic panel with spanning adjacent two first ceramic layer-forming areas among the multiple first ceramic layer-forming areas which are divided by the scribe line;
a step of splitting after the step of forming the metal layer, forming a first wiring board on which the first wiring layer and the first ceramic layers are joined by splitting the ceramic panel on which the first wiring layers are formed along the scribe line; and a step of joining after the step of splitting, manufacturing a thermoelectric conversion module in which a P-type thermoelectric conversion element and an N-type thermoelectric conversion element are connected in series, by joining the P-type thermoelectric conversion element and the N-type thermoelectric conversion element which are different in coefficient of linear expansion on a surface of the first wiring layer opposite to a surface on which the first ceramic layers are joined.

In a thermoelectric conversion module on which multiple thermoelectric conversion elements are joined (installed), it is exceedingly difficult to array and join the first ceramic layers on the first wiring layers. However, by splitting the ceramic panel along the scribe line after joining the first wiring layers on the ceramic panel as in the method of manufacturing of the present invention; it is possible to easily form the first wiring board having the first wiring layers arrayed in a prescribed pattern and the first ceramic layers which are divided into pieces, so that the thermoelectric conversion module can be smoothly manufactured. Moreover, since the first wiring layer connects the multiple ceramic layers which are divided into pieces, the first wiring board can be treated integrally and handling property can be improved.

As a preferred aspect of the method of manufacturing the thermoelectric conversion module of the present invention, it is preferable that: the step of joining be a step of joining the P-type thermoelectric conversion element and the N-type thermoelectric conversion element on the first wiring layers by disposing a bundle body in which the P-type thermoelectric conversion element and the N-type thermoelectric conversion element are layered on the first wiring layers of the first wiring board between one pair of pressurizing boards which are disposed with facing to each other, and heating the bundle body in a pressurized state in the layering direction; in the step of joining, a complement member be disposed at least between the pressurizing boards and the one thermoelectric conversion element which has smaller coefficient of linear expansion between the P-type thermoelectric conversion element and the N-type thermoelectric conversion element, and when joining the first wiring board to the P-type thermoelectric conversion element and the N-type thermoelectric conversion element, a difference between a height of the one thermoelectric conversion element and the complement member and a height of the other thermoelectric conversion element and the complement member be made smaller than a difference between a height of the one thermoelectric conversion element and a height of the other thermoelectric conversion element.

Since the first wiring board has the multiple ceramic layers which are split into pieces, when the bundle body is heated in the step of joining, the first ceramic layers are not restrained from each other by the other-side members and can follow thermal expansion of the P-type thermoelectric conversion element and the N-type thermoelectric conversion element which are layered on the respective parts. Therefore, in the step of joining, by arranging the complement member at least between the pressurizing board and the one thermoelectric conversion element having the smaller coefficient of linear expansion between the P-type thermoelectric conversion element and the N-type thermoelectric conversion element, it is possible to bring the height of the other thermoelectric conversion element having the larger coefficient of linear expansion and the height of the one thermoelectric conversion element and the complement member near while joining. Accordingly, the thermoelectric conversion elements and the first wiring layers can be closely in contact with each other and can be evenly pressurized between the pair of the pressurizing boards. As a result, the thermoelectric conversion elements and the first wiring board can be reliably joined and the bonding reliability of the thermoelectric conversion module can be improved.

As a preferred aspect of the method of manufacturing the thermoelectric conversion module of the present invention, it is preferable that: the step of joining be joining the P-type thermoelectric conversion element and the N-type thermoelectric conversion element on the first wiring layers by disposing bundle bodies in which the P-type thermoelectric conversion element and the N-type thermoelectric conversion element are layered on the first wiring layers of the first wiring board between one pair of pressurizing boards which are disposed with facing to each other, and heating the bundle bodies in a pressurized state in the layering direction, in the step of joining, the bundle bodies be arranged with even-numbers with being layered in the layering direction, and same number of the P-type thermoelectric conversion elements and the N-type thermoelectric conversion elements be arranged in the layering direction.

For instance, by arranging two of the bundle bodies which are adjacent in the layering direction among the bundle bodies so that the first wiring boards face to each other, in arranged parts of the thermoelectric conversion elements in a surface direction of the first wiring boards, it is possible to arrange the P-type thermoelectric conversion element and the N-type thermoelectric conversion element one by one (with the same number) in the layering direction. By arranging the even-numbers of bundle bodies with layering in the layering direction as above, it is always possible to layer and arrange the same number of the one thermoelectric conversion element having the smaller coefficient of linear expansion and the other thermoelectric conversion element having the larger coefficient of linear expansion between the P-type thermoelectric conversion elements and the N-type thermoelectric conversion elements. Accordingly, while joining (heating), the heights of the bundle bodies which are layered can be the same in the surface direction. Therefore, between one pair of the pressurizing boards, the thermoelectric conversion elements and the first wiring layers can be closely in contact and evenly pressurized. As a result, it is possible to reliably join the thermoelectric conversion elements and the first wiring layers, and the bonding reliability of the thermoelectric conversion module can be improved. Moreover, by layering the multiple bundle bodies, the multiple thermoelectric conversion modules can be manufactured in the step of joining once.

As a preferred aspect of the method of manufacturing the thermoelectric conversion module of the present invention, it is preferable that a graphite sheet be disposed between the bundle bodies in the step of joining.

By interposing the graphite sheet having a cushioning property between the bundle bodies, the thermoelectric conversion elements can be corrected at inclinations on arranged parts on the first wiring board in the surface direction, and the thermoelectric conversion elements and the first wiring board can be pressurized more evenly. Accordingly, the thermoelectric conversion elements and the first wiring board can be reliably joined, and it is possible to improve the bonding reliability of the thermoelectric conversion module.

As a preferred aspect of the method of manufacturing the thermoelectric conversion module of the present invention, the step of forming metal layer be a step of: forming the first wiring layers on the one surface of the ceramic panel; and forming the first heat-transmission metal layer on the other surface of the ceramic panel, and in the step of forming metal layer, the first heat-transmission metal layer be formed with spanning the adjacent two first wiring layers and formed with spanning the adjacent two first ceramic layer-forming areas.

Also in the first wiring board having the multiple first wiring layers, the first wiring layers are connected by the first heat-transmission metal layer. Accordingly, the first wiring layers can be treated integrally, and the handling property of the first wiring board can be improved. Moreover, by splitting the ceramic panel along the scribe line after joining the first wiring layers and the first heat-transmission metal layer on the ceramic panel, the first wiring board having the first wiring layers arrayed in a prescribed pattern and the first ceramic layers which are divided into pieces can be easily formed, so that the thermoelectric conversion module can be smoothly manufactured.

Moreover, in the step of joining, by interposing the graphite sheet between the bundle bodies, it is possible to prevent the thermoelectric conversion modules from joining to each other, so that the thermoelectric conversion modules can be easily separated from others. Accordingly, the thermoelectric conversion module can be stably manufactured.

As a preferred aspect of the method of manufacturing the thermoelectric conversion module of the present invention, in the step of forming scribe line, the scribe line be formed in a non-joined part on one surface of the ceramic panel excluding a planned-joining area of the first wiring layers. Moreover, it is preferable that the scribe line be formed in a non-joining part on the other surface of the ceramic panel excluding a planned-joining area of the first heat-transmission metal layer.

By forming the scribe line in the non-joining part of the first wiring layers or the non-joining part of the first heat-transmission metal layer, or in both these non-joining parts, the first ceramic layer-forming areas can be divided by the multiple scribe lines formed on both surfaces of the ceramic panel. In a case in which the first wiring layers or the first heat-transmission metal layer is layered and joined on the scribe line, it is difficult to split the ceramic panel along the scribe line. However, by forming the scribe line on a surface (an opposite surface) opposite to a surface on which the first wiring layers or the first heat-transmission metal layer is joined, the ceramic panel can be easily split along the scribe line. Accordingly, it is easy to form the first wiring board having the first wiring layers which are arrayed in a prescribed pattern and the first ceramic layers which are divided in pieces, and the thermoelectric conversion module can be smoothly manufactured.

It is preferable to form the scribe line not only in the non-joining part of the first wiring layers and the non-joining part of the first heat-transmission metal layer, but also in a joined part of the first wiring layers and a joined part of the first heat-transmission metal layer. By forming the scribe line also in the joined part of the first wiring layers and the joined part of the first heat-transmission metal layer, it is easier to split the ceramic panel.

As a preferred aspect of the method of manufacturing the thermoelectric conversion module of the present invention, it is preferable that in the step of forming scribe line, the scribe line be formed by a straight line penetrating sides of the ceramic panel which face to each other.

Since the scribe line simply penetrates the sides which face to each other in the ceramic pane; the ceramic panel can be smoothly split along the scribe line. Accordingly, the manufacturing process can be simplified.

### Advantageous Effects of Invention

According to the present invention, it is possible to prevent the thermoelectric conversion elements from breakage resulting from the difference of thermal expansion, and it is possible to provide an excellent thermoelectric conversion module in the bonding reliability, the thermal conductivity and the electrical conductivity.

### BRIEF DESCRIPTION OF DRAWINGS

[FIG. 1] It is a vertical sectional view showing a thermoelectric conversion module of a first embodiment.
[FIG. 2] It is a flow chart of a manufacturing method of the thermoelectric conversion module of the first embodiment.
[FIG. 3A] It is a vertical sectional view explaining a step of forming scribe line in the manufacturing method of the thermoelectric conversion module of the first embodiment.
[FIG. 3B] It is a vertical sectional view explaining a step of forming metal layer in the manufacturing method of the thermoelectric conversion module of the first embodiment, showing a first half part of the step.
[FIG. 3C] It is a vertical sectional view explaining the step of forming metal layer in the manufacturing method of the thermoelectric conversion module of the first embodiment, showing a second half part of the step.
[FIG. 3D] It is a vertical sectional view showing a step of splitting in the manufacturing method of the thermoelectric conversion module of the first embodiment.
[FIG. 4A] It is a perspective view explaining the step of forming scribe line in the manufacturing method of the thermoelectric conversion module of the first embodiment.
[FIG. 4B] It is a vertical sectional view explaining the step of forming metal layer in the manufacturing method of the thermoelectric conversion module of the first embodiment, showing the first half part of the step.
[FIG. 4C] It is a vertical sectional view explaining the step of forming metal layer in the manufacturing method of the thermoelectric conversion module of the first embodiment, showing the second half part of the step.
[FIG. 4D] It is a vertical sectional view explaining the step of splitting in the manufacturing method of the thermoelectric conversion module of the first embodiment.
[FIG. 5] It is a vertical sectional view explaining a step of joining of the thermoelectric conversion module of the first embodiment.
[FIG. 6] It is a vertical sectional view explaining a step of joining in another aspect.
[FIG. 7] It is a vertical sectional view explaining a step of joining in another aspect.
[FIG. 8] It is a frontal view showing a thermoelectric conversion module of a second embodiment.
[FIG. 9] It is a frontal view showing a thermoelectric conversion module of a third embodiment.
[FIG. 10] It is a plane sectional view in an arrow direction taken along the A-A line in FIG. 9.
[FIG. 11] It is a plane sectional view in an arrow direction taken along the B-B line in FIG. 9.
[FIG. 12] It is a plane sectional view in an arrow direction taken along the C-C line in FIG. 9.
[FIG. 13] It is a plane sectional view in an arrow direction taken along the D-D line in FIG. 9.
[FIG. 14A] It is a plan view in a step of forming scribe line, in which one surface of a ceramic panel which is formed faces toward a front surface side.
[FIG. 14B] It is a plan view in which the other surface of the ceramic panel which is formed in the step of forming scribe line faces toward the front surface side.
[FIG. 15A] It is a plan view in a step of forming metal layer, in which one surface of the ceramic panel in which patterns of wiring layers and heat-transmission metal layers are formed faces toward the front surface side.
[FIG. 15B] It is a plan view in the step of forming metal layer, in which the other surface of the ceramic panel in which patterns of the wiring layers and the heat-transmission metal layers are formed faces toward the front surface side.
[FIG. 16A] It is a plan view in which one surface of a first wiring board of a thermoelectric conversion module of a fourth embodiment faces toward a front surface side.
[FIG. 16B] It is a plan view in which the other surface of the first wiring board shown in FIG. 16A faces toward the front surface side.
[FIG. 17A] It is a plan view in which one surface of a first wiring board of a thermoelectric conversion module of a fifth embodiment faces toward a front surface side.
[FIG. 17B] It is a plan view in which the other surface of the first wiring board shown in FIG. 17A faces toward the front surface side.
[FIG. 18A] It is a plan view in which one surface of a first wiring board of a thermoelectric conversion module of a sixth embodiment faces toward a front surface side.
[FIG. 18B] It is a plan view in which the other surface of the first wiring board shown in FIG. 18A faces toward the front surface side.
[FIG. 19A] It is a plan view in which one surface of a first wiring board of a thermoelectric conversion module of a seventh embodiment faces toward a front surface side.
[FIG. 19B] It is a plan view in which the other surface of the first wiring board shown in FIG. 19A faces toward the front surface side.

### DESCRIPTION OF EMBODIMENTS

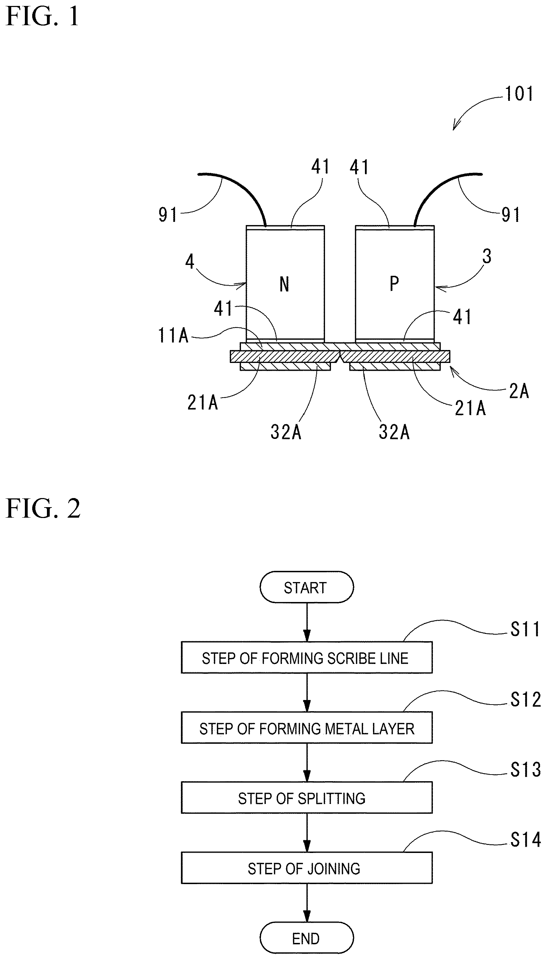

Below, embodiments of the present invention will be explained with referring the drawings. FIG. 1 shows a thermoelectric conversion module 101 of a first embodiment. The thermoelectric conversion module 101 has a structure in which a plurality of thermoelectric conversion elements 3 and 4 are arranged in pairs, a P-type thermoelectric conversion element 3 and an N-type thermoelectric conversion element 4 of the thermoelectric conversion elements 3 and 4 are electrically connected in series with a first wiring board 2A arranged at one end side (a lower side in FIG. 1) thereof. In the drawings, "P" is denoted on the P-type thermoelectric conversion element 3; and "N" is denoted on the N-type thermoelectric conversion element 4. In addition, the thermoelectric conversion module 101 has a structure in which wirings 91 to outside are directly drawn out from another ends of the thermoelectric conversion elements 3 and 4.

The P-type thermoelectric conversion element 3 and the N-type thermoelectric conversion element 4 are formed from a sintered body of, for instance, tellurium compounds, skutterudite, filled skutterudite, Heusler, half-Heusler, clathrate, silicide, oxide, silicon-germanium and the like. In addition, there are compounds which can be both the P-type and the N-type by dopants, and compounds which have a characteristic of only one of the P-type or the N-type.

As material for the P-type thermoelectric conversion element 3, used are: Bi₂Te₃, Sb₂Te₃, PbTe, TAGS (= Ag-Sb-Ge-Te), Zn₄Sb₃, CoSb₃, CeFe₄Sb₁₂, Yb₁₄MnSb₁₁, FeVAl, MnSi_{1.73}, FeSi₂, NaₓCoO₂, Ca₃Co₄O₇, Bi₂Sr₂Co₂O₇, SiGe, and the like.

As material for the N-type thermoelectric conversion element 4, used are: Bi₂Te₃, PbTe, La₃Te₄, CoSb₃, FeVAl, ZrNiSn, Ba₈Al₁₆Si₃₀, Mg₂Si, FeSi₂, SrTiO₃, CaMnO₃, ZnO, SiGe and the like.

Among these materials, silicide type material is remarkable because there are small influences on environment and large reserves of resources. As thermoelectric conversion material of the thermoelectric conversion module for medium temperature (about 300°C to 500°C), manganese silicide (MnSi_{1.73}) is used for the P-type thermoelectric conversion element 3, and magnesium silicide (Mg₂Si) is used for the N-type thermoelectric conversion element 4. Coefficient of linear expansion of manganese silicide used for the P-type thermoelectric conversion element 3 is about 10.8 × 10⁻⁶ K⁻¹: Coefficient of linear expansion of magnesium silicide used for the N-type thermoelectric conversion element 4 is about 17.0 × 10⁻⁶ K⁻¹. Accordingly, in a combination of the P-type thermoelectric conversion element 3 formed from manganese silicide and the N-type 3 formed from magnesium silicide, the coefficient of linear expansion of the P-type thermoelectric conversion element 3 is smaller than the coefficient of linear expansion of the N-type thermoelectric conversion element 4.

These thermoelectric conversion elements 3 and 4 are formed to be, for example, a rectangular rod in which a transverse section is a square (for example, a length of a side is 1 mm to 8 mm) or a round column in which a transvers section is a circle (for example, a diameter is 1 mm to 8 mm), with a length (a length along a vertical direction in FIG. 1) is 1 mm to 10 mm. The length of the P-type thermoelectric conversion element 3 and the length of the N-type thermoelectric conversion element 4 are substantially the same in room temperature (25°C). In addition, on both ends of the thermoelectric conversion elements 3 and 4, metalized layers 41 are formed from nickel, silver, gold and the like. Thickness of the metalized layer 41 is 1 µm to 100 µm (inclusive).

As shown in FIG. 1, the first wiring board 2A has a structure having a first wiring layer 11A on which the thermoelectric conversion elements 3 and 4 are joined, first ceramic layers 21A joined to a surface of the first wiring layer 11A opposite to a surface on which the thermoelectric conversion elements 3 and 4 are joined, and first heat-transmission metal layers 32A joined to surfaces of the first ceramic layers 21A opposite to surfaces on which the wiring layer 11A is joined. In addition, the first heat-transmission metal layers 32A are not essential members.

The first ceramic layers 21A are formed from common ceramic, that is a member having high thermal conductivity and insulation, such as alumina (Al₂O₃), aluminum nitride (AlN), silicon nitride (Si₃N₄), and the like. Moreover, the first ceramic layers 21A are separated into plural (two in FIG. 1), and formed independently for the each thermoelectric conversion elements 3 and 4. The first ceramic layers 21A are formed, for example, in a square shape in planar view. In addition, a thickness of the first ceramic layers 21A is 0.1 mm to 2 mm (inclusive).

The first wiring board 2A is provided with the one first wiring layer 11A with a rectangular shape in planar view and the two first heat-transmission metal layers 32A with a square shape in planar view. The first wiring layer 11A is formed so as to connect between the adjacent P-type thermoelectric conversion element 3 and N-type thermoelectric conversion element 4, and formed with spanning between the two first ceramic layers 21A and 21A. On the other hand, the first heat-transmission metal layers 32A are formed independently for the each of first ceramic layers 21A.

The first wiring layer 11A is formed from material including silver, aluminum, copper, and nickel as main ingredients into a flat shape. As material of the first wiring layer 11A, aluminum with purity 99.99% by mass or higher (so-called 4N aluminum) or copper with purity 99.9% by mass or higher are desirable. Moreover, a thickness of the first wiring layer 11A connecting the P-type thermoelectric conversion element 3 and the N-type thermoelectric conversion element 4 is preferably 0.1 mm to 2 mm (inclusive).

By forming on the first wiring layer 11A using soft material such as pure aluminum or pure copper and the like with high purity so as to form to have relatively small thickness, it is possible to deform the flat shaped first wiring layer 11A provided to connect between the adjacent thermoelectric conversion elements 3 and 4 so as to follow thermal expansion of the thermoelectric conversion elements 3 and 4, and bend between the thermoelectric conversion elements 3 and 4. In addition, since aluminum and copper are cheaper than silver, the thermoelectric conversion module 101 can be inexpensively manufactured by forming the first wiring layer 11A from aluminum or copper. Moreover, by forming the first wiring layer 11A from aluminum or copper, it is possible to favorably maintain the thermal conductivity and the electrical conductivity between the thermoelectric conversion elements 3 and 4 connected by the first wiring layer 11A.

Moreover, by using silver for the first wiring layer 11A, it is possible to favorably maintain the thermal conductivity and the electrical conductivity, and electric resistance can be low even when the thickness is relatively small. Moreover, in a case in which the first wiring board 2A including the first wiring layer 11A is arranged at a high temperature side of the thermoelectric conversion module 101 and the like, it is possible to improve heat-resisting property and resistance of oxidation. In addition, in a case in which the first wiring layer 11A is formed from silver, it is preferable that the thickness of the first wiring layer 11A be 10 µm to 200 µm (inclusive).

Moreover, nickel is inferior in the resistance of oxidation in comparison with aluminum or silver though, it has comparative good heat-resisting property. Moreover, nickel is inexpensive in comparison with silver; and bonding property of elements is relatively good. Accordingly, in a case in which nickel is used for the first wiring layer 11A, it is possible to form the thermoelectric conversion module 101 with good balance between a performance and a price. Moreover, in a case in which the first wiring board 2A including the first wiring layer 11A is arranged at the high temperature side of the thermoelectric conversion module 101, it is possible to improve the heat-resisting property and the resistance of oxidation. In addition, in a case in which the first wiring layer 11A is formed from nickel, the thickness of the first wiring layer 11A is preferably 0.1 mm to 1 mm (inclusive).

Moreover, the first heat-transmission metal layers 32A are formed from the material (aluminum, an aluminum alloy, copper, or a copper alloy) including aluminum or copper as the main ingredient into the flat plane. As material for the first heat-transmission metal layers 32A, aluminum with purity 99.99% by mass or higher (so-called 4N aluminum) or copper with purity 99.9% by mass or higher are desirable. As above, by using soft material such as pure aluminum or pure copper with high purity, following property is improved when the first heat-transmission metal layers 32A are in contact with a heat source or a cold source, and the thermal conductivity is improved. Accordingly, a property of thermoelectric conversion of the thermoelectric conversion module 101 cannot be deteriorated.

In addition, sizes (plane sizes) of the first wiring layer 11A and the first heat-transmission metal layers 32A are set to the same as or lightly larger than an area of end surfaces of the thermoelectric conversion elements 3 and 4 in accordance with a size of the thermoelectric conversion elements 3 and 4 connecting to the first wiring layer 11A. Moreover, the first ceramic layers 21A are formed in the flat plane shape which can maintain a space of a width 0.1 mm or larger around the first heat-transmission metal layers 32A and 32A and between the first heat-transmission metal layers 32A and 32A.

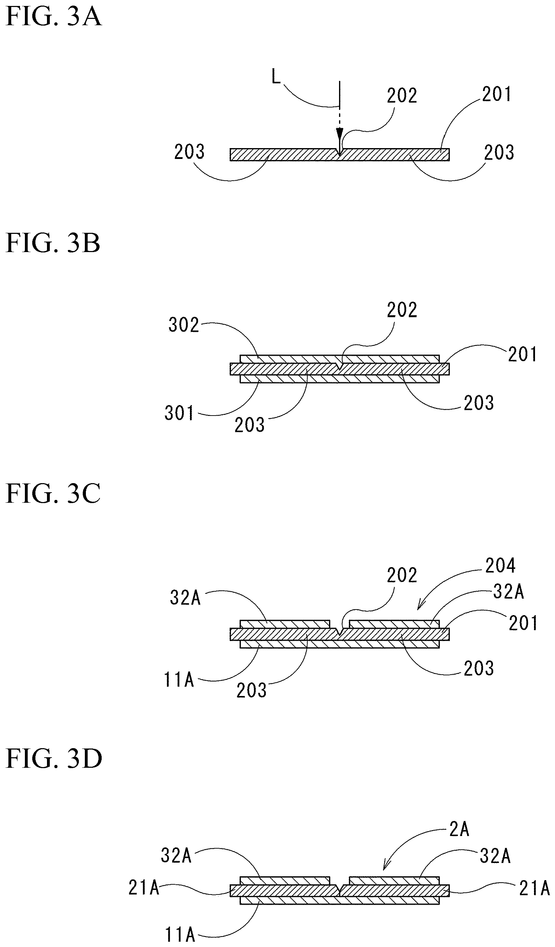

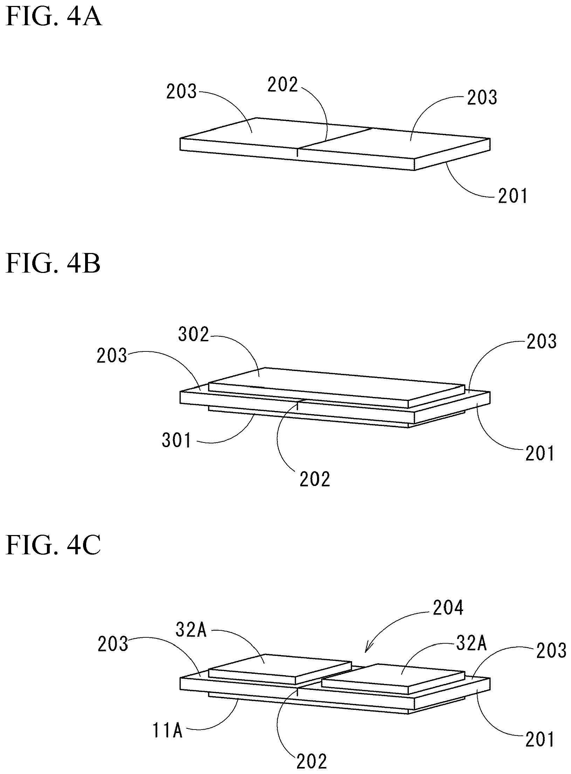

Next, a manufacturing method of the thermoelectric conversion module 101 structured as above will be explained. The manufacturing method of the thermoelectric conversion module of the present embodiment is formed from a plurality of steps S11 to S14 as shown in a flow chart of FIG. 2. Moreover, FIGS. 3A to D and FIGS. 4A to D show an example of steps in the manufacturing method of the thermoelectric conversion module of the present embodiment.

### (Step of Forming Scribe Line)

First, as shown in FIG. 3A and FIG. 4A, on a large ceramic material 201 forming the first ceramic layers 21A and 21A, a scribe line (a split groove) 202 is formed for splitting into the plurality of first ceramic layers 21A and 21A (Step of forming scribe line S11). Then, by forming the scribe line 202, the ceramic material 201 is divided into a plurality (two) of first ceramic layer-forming areas 203 and 203.

The scribe line 202 can be formed by laser working, as shown in FIG. 3A for example. Specifically, on one surface of the ceramic material 201, by irradiating laser light L such as CO2 laser, YAG laser, YVO₄ laser, YLF laser, or the like, it is possible to perform the working of the scribe line 202. In the working of the scribe line 202 by the laser working, on the surface of the ceramic material 201, a part to which the laser light L is irradiated is cut, so that the scribe line 202 is formed.

The scribe line 202 is at least formed on one surface of the ceramic panel 201 as shown in FIG. 4A. Specifically, the scribe line 202 is not formed on a joined surface of the first wiring layer 11A formed spanning the two first ceramic layers 21A and 21A, but on a surface which is opposite to that surface. That is to say, as shown in FIG. 4C, in a case in which the first wiring layer 11A is joined on one surface of the ceramic material 201, the scribe line 202 is formed in advance as shown in FIG. 4A on the other surface of the ceramic material 201 in an non-joined part excluding a planned-joining area of the first heat-transmission metal layers 32A. In addition, the scribe line 202 can be formed on the non-joined part of the first wiring layer 11A and the non-joined part of the first heat-transmission metal layers 32A; and furthermore, it can be formed on a joined part of the first wiring layer 11A and formed on both surfaces of the ceramic material 201.

Moreover, the scribe line 202 is formed by a straight line penetrating through facing sides in the ceramic material 201 as shown in FIG. 4A. In this case, one scribe line 202 penetrating long sides is formed on the ceramic material 201; the ceramic material 201 is split into two by the one scribe line 202; and two first ceramic layer-forming areas 203 divided to have a size of an outline shape of the first ceramic layers 21A and 21A are formed in line.

In addition, although illustration is omitted, the ceramic material 201 on which the scribe line 202 is formed is cleaned by soaking in etchant.

Moreover, the step of forming scribe line S11 is not limited to laser working, and can be performed by the other working method such as diamond scriber and the like.

### (Step of Forming Metal Layer)

After the step of forming scribe line S11, the first wiring layer 11A is formed on one surface of the ceramic material 201, and the first heat-transmission metal layers 32A are formed on the other surface (a step of forming metal layer S12). For example, as shown in FIG. 3B and FIG. 4B, on one surface of the ceramic material 201, i.e., on the surface on which the scribe line 202 is not formed, a metal board 301 which will be the first wiring layer 11A is joined; and on the other surface on which the scribe line 202 is formed, a metal board 302 which will be the first heat-transmission metal layers 32A is joined. The metal board 301 and the ceramic material 201, and the ceramic material 201 and the metal board 302 are joined using brazing material or the like.

In a case in which the metal boards 301 and 302 are formed from metal material including aluminum as a main ingredient, the metal boards 301 and 302 are joined to the ceramic material 201 using joining material such as Al-Si, Al-Ge, Al-Cu, Al-Mg, Al-Mg, and the like. Moreover, in a case in which the metal boards 301 and 302 are formed from metal material including copper as a main ingredient, the metal boards 301 and 302 are joined to the ceramic material 201 by active-metal brazing using joining material such as Ag-Cu-Ti, Ag-Ti, and the like. Moreover, it is possible to join the metal board 301 and 302 to the ceramic material 201 by a bonding method of a transient liquid phase so-called a TLP bonding (Transient Liquid Phase Bonding), other than brazing.

Next, etching is performed on the ceramic material 201 on which the metal boards 301 and 302 are joined; as shown in FIG. 3C and FIG. 4C, the first wiring layer 11A arranged with spanning on the first ceramic layer-forming areas 203 and 203 is patterned on one surface of the ceramic material 201; and on the other surface of the ceramic material 201, the first heat-transmission metal layers 32A and 32A are individually patterned on the first ceramic layer-forming areas 203. The scribe line 202 is formed on the non-joined part excluding the planned-joining area of the first heat-transmission metal layers 32A and 32A. Accordingly, by removing a part of the metal layer (the metal board) formed being with layered on the scribe line 202, the whole scribe line 202 can be exposed. As a result, a layered body 204 having the first wiring layer 11A and the first heat-transmission metal layers 32A and 32A which are patterned and the ceramic material 201 is formed.

In addition, the first wiring layer 11A can also be formed without performing the etching but by joining a metal board which is patterned in advance on one surface of the ceramic material 201. Similarly, the first heat-transmission metal layers 32A and 32A also can be formed without etching but by joining pieces of metal board which are patterned in advance on the other surface of the ceramic material 201.

Moreover, the first wiring layer 11A can also be structured from a sintered body of silver (Ag). In a case in which the first wiring layer 11A is structured from the sintered body of silver, on one surface of the ceramic material 201, glass-including-silver paste including silver and glass is spread and a heat treatment is performed, so it can be formed by sintering the silver paste. Accordingly, the first wiring layer 11A which is patterned can be formed without performing the etching. In addition, in a case in which the first wiring layer 11A is structured from the sintered body of silver, it is preferable that at least a surface of the ceramic material 201 in contact with a boundary to the silver paste be structured from alumina (Al₂O₃). In this case, for example, the whole of the ceramic material 201 can be structured from alumina; or a ceramic board in which aluminum nitride is oxidized and a surface has become alumina may be used.

### (Step of Splitting)

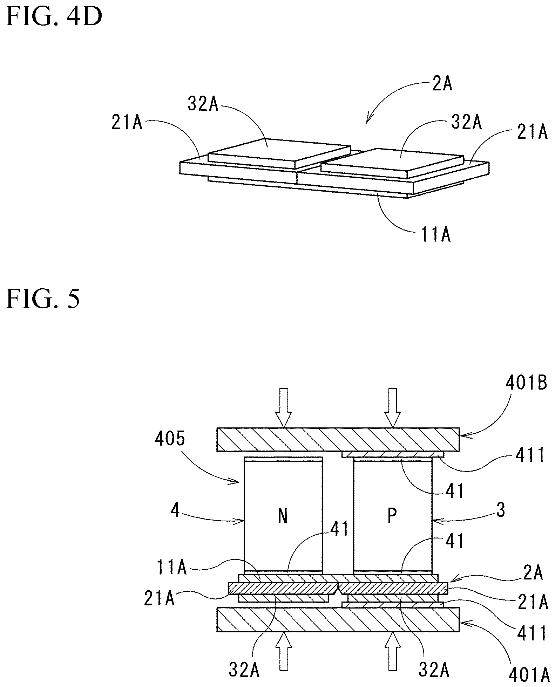

After the step of forming metal layer S12, the ceramic material 201 is bent so as to swell in the side of the surface on which the scribe line 202 is formed, and the ceramic material 201 of the layered body 204 is split along the scribe line 202; so that the first ceramic layers 21A and 21A are divided into pieces. Then, as shown in FIG. 3D and FIG. 4D, the first wiring board 2A in which the first wiring layer 11A, the first ceramic layers 21A and 21A, and the first heat-transmission metal layers 32A and 32A are joined is formed (a step of splitting S13).

The scribe line 202 is formed on an opposite side to the joined surface to the first wiring layer 11A (the opposite surface), so that the ceramic material 201 can be easily split along the scribe line 202. Moreover, the scribe line 202 is formed in a simple straight line running through the facing sides to each other of the ceramic material 201, so that the ceramic material 201 can be smoothly split along the scribe line 202.

### (Step of Joining)

On the first wiring layer 11A of the first wiring board 2A, one end surface of the P-type thermoelectric conversion element 3 and one end surface of the N-type thermoelectric conversion element 4 are joined (a step of joining S14). Specifically, the first wiring layer 11A is joined to the P-type thermoelectric conversion element 3 and the N-type thermoelectric conversion element 4 by using paste or brazing material, or solid-phase diffusion bonding with adding load.

In the step of joining S14, in order to add appropriate load for joining of the first wiring layer 11A to the P-type thermoelectric conversion element 3 and the N-type thermoelectric conversion element 4, as shown in FIG. 5, between a pair of pressurizing boards 401A and 401B which are arranged facing to each other, a bundle body 405 in which the P-type thermoelectric conversion element 3 and the N-type thermoelectric conversion element 4 are layered on the first wiring layer 11A of the first wiring board 2A is arranged, and the bundle body 405 is heated in a state being pressurized in a layering direction thereof. Thereby the P-type thermoelectric conversion element 3 and the N-type thermoelectric conversion element 4 are joined respectively to the first wiring layer 11A. In this case, the pressurizing boards 401A and 401B are structured from carbon boards.

When joining the P-type thermoelectric conversion element 3 and the N-type thermoelectric conversion element 4 to the first wiring layer 11A, complement members 411 are arranged between at least one thermoelectric conversion element having smaller coefficient of linear expansion between the P-type thermoelectric conversion element 3 and the N-type thermoelectric conversion element 4 and the pressurizing boards 401A and 401B, so that a difference of thermal expansion resulting from a difference of linear expansion between the P-type thermoelectric conversion element 3 and the N-type thermoelectric conversion element 4 is compensated. Specifically, in a combination of the P-type thermoelectric conversion element 3 of manganese silicide (coefficient of linear expansion about 10.8 × 10⁻⁶ K⁻¹) and the N-type thermoelectric conversion element 4 of magnesium silicide (coefficient of linear expansion about 17.0 × 10⁻⁶ K⁻¹), the coefficient of linear expansion of the P-type thermoelectric conversion element 3 is smaller than the coefficient of linear expansion of the N-type thermoelectric conversion element 4. Therefore, the complement members 411 are arranged at least between the P-type thermoelectric conversion element 3 having the small coefficient of linear expansion and the pressurizing boards 401A and 401B.

In addition, it is easy to handle the complement members 411 by integrating by fixing to the pressurizing boards 401A and 401B in advance. Moreover, the illustration is omitted though, arranged is a graphite sheet for preventing joining between the complement members 411 and the metalized layer 41 or the first heat-transmission metal layer 32A of the P-type thermoelectric conversion element 3.

As shown in FIG. 5, for example, in a case in which the complement member 411 is arranged at the P-type thermoelectric conversion element 3 side only, it is necessary for the complement member 411 to use material having the higher coefficient of linear expansion than that of the N-type thermoelectric conversion element 4. For example, aluminum (23 × 10⁻⁶ K⁻¹) exemplifies material having higher coefficient of linear expansion than the coefficient of linear expansion of the N-type thermoelectric conversion element 4 (about 17.0 × 10⁻⁶ K⁻¹). This material is used for the complement material 411.

And a different between a height of the P-type thermoelectric conversion element 3 and the complement members 411 and a height of the N-type thermoelectric conversion element 4 when the P-type thermoelectric conversion element 3 and the N-type thermoelectric conversion element 4 are joined to the first wiring board 2A is smaller than a difference between a height of the P-type thermoelectric conversion element 3 and the height of the N-type thermoelectric conversion element 4. Accordingly, it is possible that the height of the N-type thermoelectric conversion element 4 with the larger coefficient of linear expansion to be close to the height of the P-type 4 with the smaller coefficient of linear expansion and the complement member 411. Therefore, the thermoelectric conversion elements 3 and 4 are closely in contact with the first wiring layer 11A and can be pressurized with even load respectively between the pair of the pressurizing boards 401A and 401B.

In addition, in the example shown in FIG. 5, the complement member 411 is arranged between the lower pressurizing board 401A and the bundle body 405 and the complement member 411 is arranged between the upper pressurizing board 401B and the bundle body 405: the complement member 411 may be arranged in either one interval of them.

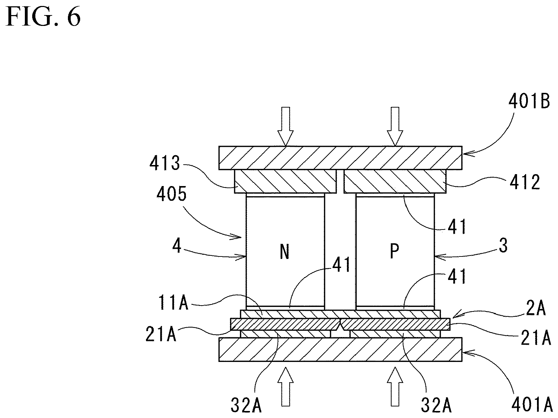

In addition, as shown in FIG. 6, the step of joining S14 can be performed with arranging complement members 412 and 413 at both of the P-type thermoelectric conversion element 3 side and the N-type thermoelectric conversion element 4. For example, arranged on the side of the P-type thermoelectric conversion element 3 with the smaller coefficient of linear expansion is the complement member 412 with large coefficient of linear expansion: arranged on the side of the N-type thermoelectric conversion element 4 with the large coefficient of linear expansion is the complement member 413 with smaller coefficient of linear expansion than that of the complement member 412. In addition, the illustration is omitted though, graphite sheets for preventing being joined are arranged in the respective intervals between the complement members 412 and 413 and the metalized layers 41 of the thermoelectric conversion elements 3 and 4.

For example, as material of the complement member 412 arranged at the side of the P-type thermoelectric conversion element 3, aluminum (23 × 10⁻⁶ K⁻¹) and copper (17 × 10⁻⁶ K⁻¹) can be used. Moreover, as material of the complement member 413 arranged at the side of the N-type thermoelectric conversion element 4, iron (12 × 10⁻⁶ K⁻¹) and nickel (13 × 10⁻⁶ K⁻¹) can be used.

Thereby, in joining the P-type thermoelectric conversion element 3 and the N-type thermoelectric conversion element 4 to the first wiring board 2A, reducing the difference between the height of the P-type thermoelectric conversion element 3 and the complement member 412 and the height of the N-type thermoelectric conversion element 4 and the complement member 413 than the difference between the height of the P-type thermoelectric conversion element 3 and the height of the N-type thermoelectric conversion element 4; so that it is possible to align the height of the P-type thermoelectric conversion element 3 and the complement member 412 and the height of the N-type thermoelectric conversion element 4 and the complement member 413. Accordingly, between a pair of the pressurizing boards 401A and 401B, the thermoelectric conversion elements 3 and 4 are closely in contact with the first wiring layer 11A and can be evenly pressurized.

In addition, in the above, the complement member 412 made of material with the large coefficient of linear expansion is arranged at the side of the P-type thermoelectric conversion element 3 having the small coefficient of linear expansion; and the complement member 413 made of material having the smaller coefficient of linear expansion than the complement member 412 is arranged at the side of the N-type thermoelectric conversion element 4 having the large coefficient of linear expansion: however, it is possible that a complement member made of material having small coefficient of linear expansion is arranged at the side of the P-type thermoelectric conversion element 3, and a complement member made of having large coefficient of linear expansion is arranged at the side of the N-type thermoelectric conversion element 4. In this case, in order to make a height at a side of the P-type thermoelectric conversion element 3 and a height at a side of the N-type thermoelectric conversion element 4 even when joining (heating) the P-type thermoelectric conversion element 3 and the N-type thermoelectric conversion element 4 to the first wiring board 2A, it is enough to adjust thicknesses of the complement members.

In addition, since the first wiring board 2A has the first ceramic layers 21A and 21A which are separated in pieces, the first ceramic layers 21A and 21A does not fix the other when the bundle body 405 is heated in the step of joining S14. Accordingly, it is possible to move in accordance with thermal expansion of the P-type thermoelectric conversion element 3 and the N-type thermoelectric conversion element 4 layered on the respective parts of the first wiring board 2A. Thereby producing the thermoelectric conversion module 101 in which the P-type thermoelectric conversion element 3 and the N-type thermoelectric conversion element 4 are connected in series with the first wiring board 2A therebetween.

In the thermoelectric conversion module 101 produced as above, for example, an external heat source (not illustrated) and a cooling path (not illustrated) are arranged on a lower side in FIG. 1. Thereby generating electromotive force in accordance with a difference between the upper temperature and the lower temperature in the thermoelectric conversion elements 3 and 4; between the wirings 91 and 91 at both the ends of the arrangement, it is possible to obtain an electric potential difference of total sum of the electromotive force generated in the thermoelectric conversion elements 3 and 4.

Moreover, under such a usage environment, the thermoelectric conversion elements 3 and 4 in the thermoelectric conversion module 101 differ in the thermal expansion. However, in the thermoelectric conversion module 101, the first ceramic layers 21A and 21A structuring the first wiring board 2A are separated at the adjacent P-type 3 and the N-type thermoelectric conversion element 4, so that the thermoelectric conversion elements 3 and 4 are independently formed: the connection between the P-type thermoelectric conversion element 3 and the N-type thermoelectric conversion element 4 in the rigid first wiring boards 21A and 21A is interrupted. Accordingly, the thermoelectric conversion elements 3 and 4 are not fixed by the first ceramic layers 21A and 21A in the deformation by the thermal expansion.

Moreover, a dimensional change by a difference of thermal expansion between the adjacent P-type 3 and N-type can be absorbed by deformation of a connecting part of the first wiring layer 11A connecting the thermoelectric conversion elements 3 and 4. Accordingly, thermal stress generated in the thermoelectric conversion elements 3 and 4 resulting from the difference of the thermal expansion can be prevented. Then, it is possible to prevent the thermoelectric conversion elements 3 and 4 being peeled off from the first wiring board 2A (the first wiring layer 11A) or the thermoelectric conversion elements 3 and 4 being cracked resulting from the difference between the thermal expansion of the thermoelectric conversion elements 3 and 4. Accordingly, it is possible to favorably maintain the electrical connection between the thermoelectric conversion elements 3 and 4 connected by the first wiring layer 11A, and it is possible to favorably maintain the joining reliability, the thermal conductivity and the electrical conductivity of the thermoelectric conversion module 101.

Moreover, on the first wiring board 2A, the first ceramic layers 21A and 21A which are insulating boards are provided. Therefore, when the thermoelectric conversion module 101 is installed on the heat source or the like, it is possible to prevent the first wiring layer 11A from being contact with the heat source or the like by the first ceramic layers 21A and 21A. Accordingly, it is possible to reliably avoid electric leakage between the heat source or the like and the first wiring layer 11A, and favorably maintain an insulation state.

In addition, since a voltage is low in the thermoelectric conversion elements 3 and 4 themselves, as long as the first ceramic layers 21A and 21A which are insulation boards are independently formed on the respective 3 and 4, even if the first ceramic layers 21A and 21A are not joined on the whole surface of the first wiring layer 11A, the electric leakage does not arise unless the first wiring layer 11A is in physically contact with the heat source or the like.

Moreover, since the first heat-transmission metal layers 32A and 32A are provided on the first wiring board 2A, when the thermoelectric conversion module 101 is installed on the heat source or the like, it is possible to improve an adhesion property of the heat source or the like and the thermoelectric conversion module 101 by the first heat-transmission metal layers 32A and 32A, so that the thermal conductivity can be improved. Accordingly, it is possible to improve the thermoelectric conversion property (power generation efficiency) in the thermoelectric conversion module 101.

In addition, in the step of joining S14 in the first embodiment, as shown in FIG. 5 and FIG. 6, by using the complement members 411 to 413, the complement members 411 to 413 are arranged between at least one thermoelectric conversion element (the P-type thermoelectric conversion element 3) having the small coefficient of thermal expansion and the pressurizing boards 401A and 401B, so that the difference between the thermal expansion between the P-type thermoelectric conversion element 3 and the N-type thermoelectric conversion element 4 was supplemented. And, it was decided that the thermoelectric conversion elements 3 and 4 were closely in contact with the first wiring layer 11A and evenly pressurized between the pair of the pressurizing boards 401A and 401B: however, the step of joining is not limited to this.

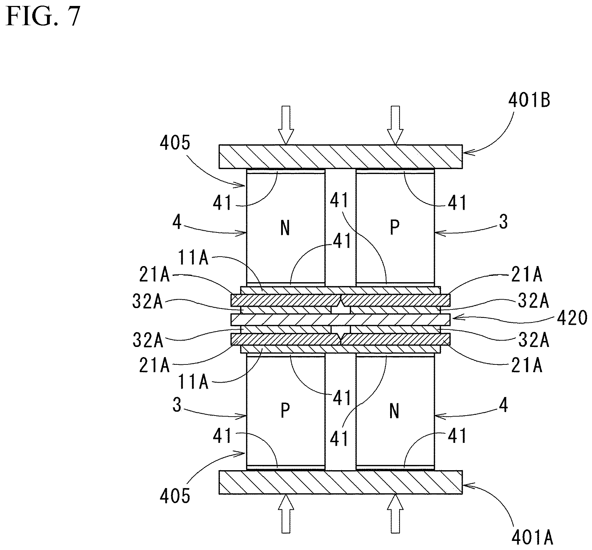

For example, as shown in FIG. 7, the bundle bodies 405 with even numbers (two in FIG. 7) are arranged with layered in the layering direction, and the P-type thermoelectric conversion element 3 and the N-type thermoelectric conversion element 4 with the same numbers are arranged in the layering direction: it is possible to evenly pressurize the thermoelectric conversion elements 3 and 4 to the first wiring layer 11A with closely being in contact to each other respectively when joining the P-type thermoelectric conversion element 3 and N-type 4 to the first wiring layer 11A. Moreover, by arranging a graphite sheet having a cushion property between the bundle bodies 405 and 405, inclinations can be corrected respectively at the arranged parts of the thermoelectric conversion elements 3 and 4 in a surface direction of the first wiring board 2A: it is possible to pressurize the thermoelectric conversion elements 3 and 4 to the first wiring board 2A more evenly.

In this case, by arranging the first wiring board 2A and 2A of the two bundle bodies 405 and 405 which are adjacent in the layering direction with facing to each other, it is possible to arrange the P-type thermoelectric conversion element 3 and the N-type thermoelectric conversion element 4 one by one (with the same numbers)in the layering direction on the arranging positions of the thermoelectric conversion elements 3 and 4 in the surface direction of the first wiring board 2A. By arranging the bundle bodies 405 and 405 layering in the layering direction with even numbers as described above, between the P-type thermoelectric conversion element 3 and the N-type thermoelectric conversion element 4, it is possible to arrange by layering one thermoelectric conversion element with the small coefficient of linear expansion and the other thermoelectric conversion element with the large coefficient of linear expansion with the same numbers at all times: when joining (heating), the bundle bodies 405 and 405 in which pluralities are layered can be even in the height in the surface direction. Moreover, as described above, by interposing the graphite sheets 420 having the cushion property between the bundle bodies 405 and 405, the inclinations thereof can be corrected, so that the thermoelectric conversion elements 3 and 4 and the first wiring board 2A can be more evenly pressurized.

Accordingly, the thermoelectric conversion elements 3 and 4 and the wiring layer 11A are closely in contact with each other and can be evenly pressurized between the pair of the pressurizing boards 401A and 401B, and it is possible to reliably join the thermoelectric conversion elements 3 and 4 to the first wiring board 2A. Moreover, by layering the plurality of the bundle bodies 405 as above, the plurality of the thermoelectric conversion module 101 can be produced in one step of joining S14.

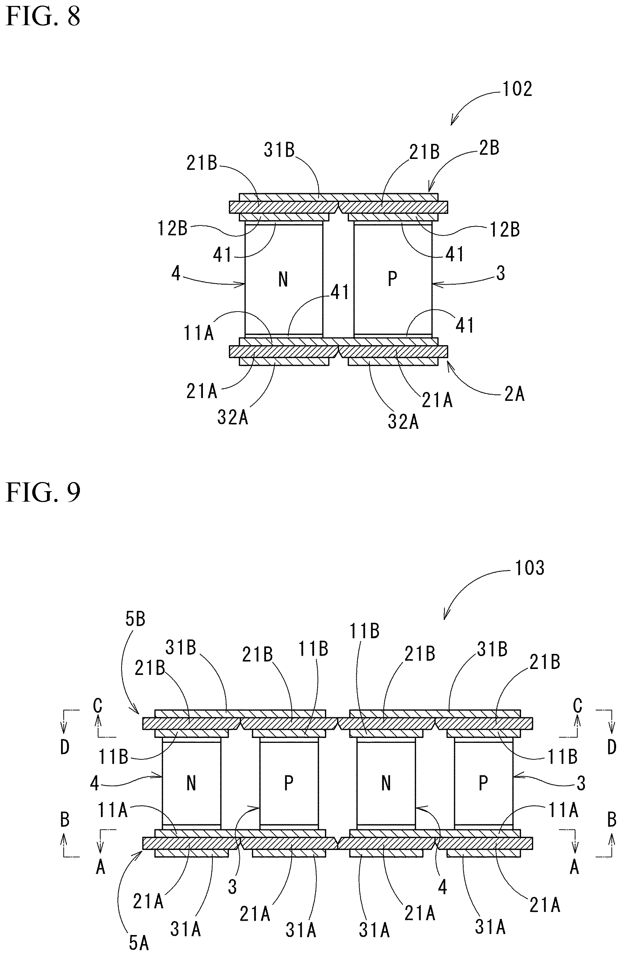

Moreover, in the first embodiment shown in FIG. 1, the structure has the first wiring board 2B arranged at one end side of the thermoelectric conversion elements 3 and 4: it is also possible to arrange the first wiring board 2B on one end side of the thermoelectric conversion elements 3 and 4 (a lower side in FIG. 8) and arrange a second wiring board 2B on the other end side (an upper side in FIG. 8) as in a thermoelectric conversion module 102 of a second embodiment shown in FIG. 8. In this case, the P-type thermoelectric conversion element 3 and the N-type thermoelectric conversion element 4 can be electrically connected in series with interposing the first wiring board 2B and the second wiring board 2B disposed with facing to each other.

Below, in the thermoelectric conversion module 102 of the second embodiment, common elements to that in the thermoelectric conversion module 101 of the first embodiment are denoted by the same symbols and explanation will be omitted. The first wiring board 2B disposed at the one end side (the lower side in FIG. 8) of the thermoelectric conversion elements 3 and 4 is the same in the first embodiment and the explanation is omitted.

The second wiring board 2B disposed at the other end side (the upper side in FIG. 8) of the thermoelectric conversion elements 3 and 4 has a structure having: second wiring layers 12B and 12B; second ceramic layers 21B and 21B joined on opposite surfaces to surfaces on which the thermoelectric conversion elements 3 and 4 are joined of the second wiring layers 12B and 12B; and a second heat-transmission metal layer 31B joined on opposite surfaces to surfaces on which the second wiring layers 12B and 12B are joined of the second ceramic layers 21B and 21B.

The second ceramic layers 21B and 21B forming the second wiring board 2B are separated into plural (two in FIG. 8), and formed independently for the thermoelectric conversion elements 3 and 4 respectively as in the first embodiment. The second ceramic layers 21B and 21B are formed in a square shape in planar view. On the second wiring board 2B, the second wiring layers 12B and 12B having the square shape in the planar view are provided with two and the second heat-transmission metal layer 31B having a rectangular shape in planar view is provided with one. The second wiring layers 12B and 12B are formed independently on the second ceramic layers 21B and 21B respectively, and connected to the thermoelectric conversion elements 3 and 4 individually. On the other hand, the second heat-transmission metal layer 31B is formed with spanning the adjacent second wiring layers 12B and 12B and spanning the adjacent second ceramic layers 21B and 21B.

In the thermoelectric conversion module 102 of the second embodiment, the first wiring layer 11A of the first wiring board 2B and the second heat-transmission metal layer 31B of the second wiring board 2B are formed from the same metal material into the same shape (the same thickness and the same plane size); and the first heat-transmission metal layer 32A and 32A of the first wiring board 2B and the second wiring layers 12B and 12B of the second wiring board 2B are formed from the same metal material into the same shape. The first wiring board 2B and the second wiring board 2B have a structure having: two ceramic layers (the 21A and 21A or the 21A and 21B); the metal layer (the first wiring layer 11A or the second heat-transmission metal layer 31B) with the rectangular shape in the planar view, which is joined to the surfaces at the one side of both the ceramic layers; the metal layers (the first heat-transmission metal layer 32A and 32A or the second wiring layers 12B and 12B) with the square shape in the planar view, which are joined to the surfaces of the other side of both the ceramic layers and formed on both the ceramic layers independently. That is to say, both the wiring boards 2A and 2B are formed from the one type of wiring board having the same structure.

Between one pair of the wiring boards 2A and 2B formed as above, the P-type thermoelectric conversion element 3 and the N-type thermoelectric conversion element 4 are alternately connected in series, so that the thermoelectric conversion module 102 is structured. Accordingly, an explanation of a method of manufacturing the thermoelectric conversion module 102 is omitted.

As well in the thermoelectric conversion module 102 of the second embodiment manufactured as above, the ceramic layers 21A and 21B forming the respective wiring boards 2A and 2B are formed independently on the thermoelectric conversion elements 3 and 4 respectively; so that the connection between the P-type thermoelectric conversion element 3 and the N-type thermoelectric conversion element 4 in the rigid ceramic layers 21A and 21B is interrupted. Accordingly, the ceramic layers 21A and 21B do not fix the deformation of the thermoelectric conversion elements 3 and 4 by the thermal expansion.

Moreover, the 21A and 21A of the first wiring board 2B are connected only by the first wiring layer 11A; and the second ceramic layers 21B and 21B of the second wiring board 2B are connected only by the second heat-transmission metal layer 31B. Accordingly, the dimensional change by a difference of thermal expansion between the adjacent P-type 3 and N-type 4 can be absorbed by deformation of connection parts of the first wiring layer 11A or the second heat-transmission metal layer 31B connecting between the thermoelectric conversion elements 3 and 4. Accordingly, it is possible to reduce the thermal stress generated in the thermoelectric conversion elements 3 and 4 by the difference of the thermal expansion. And, it is possible to prevent the thermoelectric conversion elements 3 and 4 from being peeled off from the wiring boards 2A and 2B (the first wiring layer 11A or the second wiring layers 12B and 12B) or from cracking resulting from the difference of the thermal expansion of the thermoelectric conversion elements 3 and 4. Accordingly, it is possible to favorably maintain the electrical connection between the thermoelectric conversion elements 3 and 4 which are connected by the first wiring layer 11A and the second wiring layers 12B and 12B: it is possible to favorably maintain joining reliability, thermal conductivity, and electrical conductivity in the thermoelectric conversion module 102.

Moreover, since the respective wiring boards 2A and 2B are provided with the ceramic layers 21A and 21B which are insulation boards; when the thermoelectric conversion module 102 is installed on a heat source or the like, it is possible to prevent the heat source or the like being in contact with the first wiring layer 11A or the second wiring layers 12B and 12B by the ceramic layers 21A and 21B. Accordingly, it is possible to reliably avoid an electric leak between the heat source or the like and the first wiring layer 11A or the second wiring layers 12B and 12B: an insulation state can be favorably maintained.

Moreover, the wiring boards 2A and 2B are provided with the first heat-transmission metal layer 32A and the second heat-transmission metal layer 31B. Therefore, when the thermoelectric conversion module 102 is installed on the heat source or the like, it is possible to improve an adhesion property of the heat source or the like and the thermoelectric conversion module 102 by the first heat-transmission metal layers 32A and 31B and improve the thermal conductivity. Accordingly, it is possible to improve the thermoelectric conversion property (power generation efficiency) of the thermoelectric conversion module 102.

In addition, the second embodiment shown in FIG. 8 has a structure in which the pair of the wiring boards 2A and 2B are both provided with the 21A and 21A or the second ceramic layers 21B and 21B formed independently on the thermoelectric conversion elements 3 and 4 respectively: however, it is not limited to this. If at least only one of the wiring boards has a structure having ceramic layers formed independently on the respective thermoelectric conversion elements 3 and 4: it is possible to reduce the dimensional change of the thermoelectric conversion elements 3 and 4 and the difference of thermal expansion between the thermoelectric conversion elements 3 and 4, and it is possible to prevent the thermoelectric conversion elements 3 and 4 from cracking resulting from the difference of thermal expansion and peeling off from a pair of the wiring boards. Accordingly, it is enough to form at least one ceramic layer of the pair of 2A and 2B independently on the thermoelectric conversion elements 3 and 4.

FIG. 9 to FIG. 13 show a thermoelectric conversion module 103 of a third embodiment of the present invention. In the first embodiment and the second embodiment, the thermoelectric conversion modules 101 and 102 were structured by pairing the P-type thermoelectric conversion element 3 and the N-type thermoelectric conversion element 4 one by one: however, as in the thermoelectric conversion module 103 of the third embodiment, a large thermoelectric conversion module can be structured by assembling a plurality of the P-type thermoelectric conversion elements 3 and the N-type thermoelectric conversion elements 4.

In the thermoelectric conversion module 103 of the third embodiment, a plurality of the P-type thermoelectric conversion elements 3 and the N-type thermoelectric conversion elements 4 are paired and arranged in a surface (two-dimensional) between a first wiring board 5A and a second wiring board 5B which are arranged with facing to each other, i.e., between a pair of the wiring boards 5A and 5B. The structure is set in that respective P-type 3 and the N-type thermoelectric conversion element 4 are electrically connected in series with interposing the upper and lower wiring boards 5A and 5B. Hereinafter, in the thermoelectric conversion module 103 of the third embodiment, common elements to that of the thermoelectric conversion module 101 in the first embodiment and the 102 in the second embodiment 102 are denoted by the same symbols and the explanation thereof is omitted.

As shown in FIG. 9 to FIG. 13, a structure of the first wiring board 5A has: the plurality of first wiring layers 11A and 12A; a plurality of first ceramic layers 21A joined on a surface opposite to a surface on which the thermoelectric conversion elements 3 and 4 of the first wiring layers 11A and 12A are joined; and a first heat-transmission metal layers 31A joined on a surface opposite to a surface on which the first wiring layers 11A and 12A of the ceramic layers 21A are joined.

Moreover, as shown in FIG. 9, FIG. 12, and FIG. 13, a structure of the second wiring board 5B has: second wiring layers 11B; a plurality of the second ceramic layers 21B joined on surfaces opposite to surfaces on which the thermoelectric conversion elements 3 and 4 of the second wiring layers 11B are joined; and second heat-transmission metal layers 31B and 32B joined on surfaces opposite to surfaces on which the second wiring layers 11B of the second ceramic layers 21B are joined.

The ceramic layers 21A and 21B forming the first wiring board 5A and 5B are formed independently on the thermoelectric conversion elements 3 and 4 as in the first embodiment. In addition, in the thermoelectric conversion module 103, the P-type thermoelectric conversion element 3 and the N-type thermoelectric conversion element 4 are provided with seven respectively: fourteen thermoelectric conversion elements are provided in total. Moreover, the first wiring board 5A and 5B are provided with the ceramic layers 21A and 21B with sixteen respectively, which are more than the number of the thermoelectric conversion elements 3 and 4.

Furthermore, the ceramic layers 21A of the first wiring board 5A are connected by the first wiring layer 11A or the first heat-transmission metal layers 31A: the ceramic layers 21A forming the first wiring board 5A are provided integrally. On the other hand, the second ceramic layers 21B of the second wiring board 5B are connected by the second wiring layers 11B or the second heat-transmission metal layers 31B: the second ceramic layers 21B forming the second wiring board 5B are provided integrally.

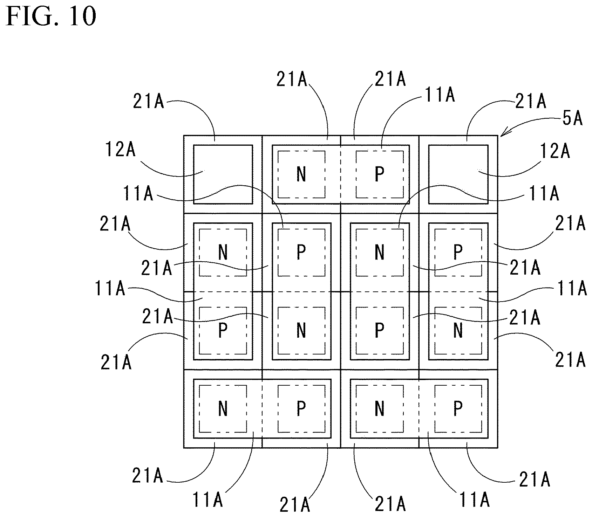

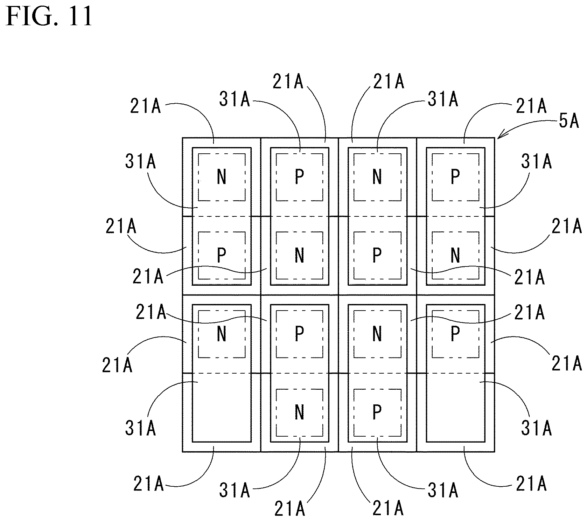

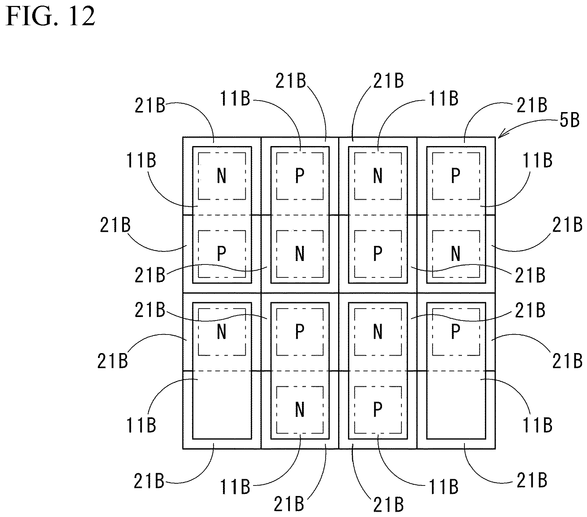

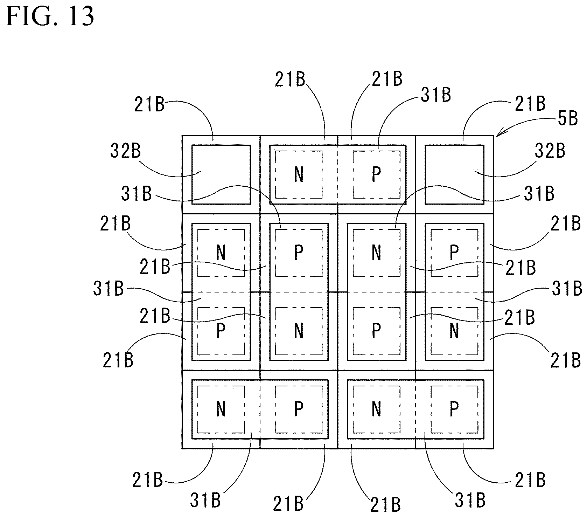

In the first wiring board 5A disposed at a lower side of FIG. 9, the first wiring layer 11A with seven having a rectangular shape in planar view and the 12A with two having a square shape in the planar view are provided as shown in FIG. 10: the first heat-transmission metal layers 31A with eight having a rectangular shape in the planar view are provided as shown in FIG. 11. Moreover, the second wiring board 5B disposed at an upper side of FIG. 9 is provided with the second wiring layers 11B with eight having a rectangular shape in planar view as shown in FIG. 12, and provided with the second heat-transmission metal layers 31B with seven having a rectangular shape in planar view and the second heat-transmission metal layers 32B with two having a square shape in planar view as shown in FIG. 13.

The first wiring layers 11A are formed so as to connect the P-type thermoelectric conversion element 3 and the N-type thermoelectric conversion element 4 which are adjacent, with spanning the first ceramic layers 21A and 21A of the thermoelectric conversion elements 3 and 4. On the other hand, the 12A are formed independently only on the ceramic layers 21A on which the first wiring layers 11A are not formed. Moreover, the first heat-transmission metal layers 31A are formed with spanning the first wiring layers 11A and 11A which are adjacent, and formed with spanning the first ceramic layers 21A and 21A which are adjacent.

Moreover, the second wiring layers 11B of the second wiring board 5B are formed with connecting the P-type thermoelectric conversion element 3 and the N-type thermoelectric conversion element 4 which are adjacent, and formed with spanning the second ceramic layers 21B and 21B of the thermoelectric conversion elements 3 and 4. Moreover, the second heat-transmission metal layers 31B are formed with spanning the second wiring layers 11B and the second wiring layers 11B which are adjacent, and formed with spanning the second ceramic layers 21B and 21B which are adjacent. On the other hand, the second heat-transmission metal layers 32B are formed independently only on the second ceramic layers 21B on which the second heat-transmission metal layers 32B are not formed.

Moreover, the first wiring layer 11A of the first wiring board 5A and the second heat-transmission metal layers 31B of the second wiring board 5B are formed of a same metal material into a same shape (a same thickness and a same plane size). Moreover, the 12A of the first wiring board 5A and the second heat-transmission metal layers 32B of the second wiring board 5B are formed of a same metal material into a same shape. Moreover, the first heat-transmission metal layers 31A of the first wiring board 5A and the second wiring layers 11B of the second wiring board 5B are formed of a same metal material into a same shape. As described above, the first wiring board 5A and the second wiring board 5B are structured from one type of wiring boards having the same structure. Then, between the one pair of 5A and 5B structured as above, the P-type thermoelectric conversion element 3 and the N-type thermoelectric conversion element 4 are alternately connected in series, so that the thermoelectric conversion module 103 is structured.

Next, a method of manufacturing the thermoelectric conversion module 103 structured as above will be explained. The method of manufacturing the thermoelectric conversion module of the third embodiment is structured from a same flow as the flow of the method of manufacturing the thermoelectric conversion module of the first embodiment. Accordingly, the method of the thermoelectric conversion module of the third embodiment will also be explained using the flow chart of FIG. 2. Moreover, since the first wiring board 5A and the second wiring board 5B are structured from the one type wiring board having the same structure: explanation of steps of producing the second wiring board 5B is omitted in the steps S11 to S13, and only steps of producing the first wiring board 5A will be explained.

### (Step of Forming Scribe Line)

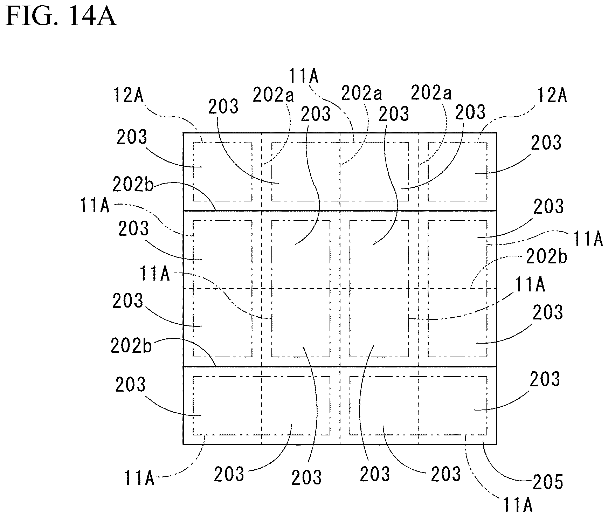

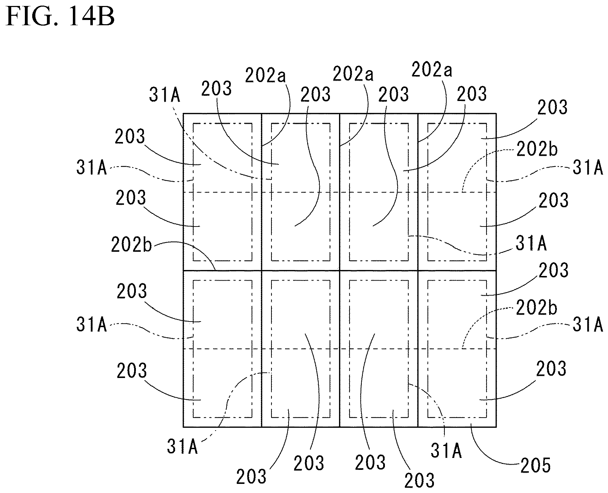

First, as shown in FIG. 14A and FIG. 14B, scribe lines 202a and 202b are formed on a large ceramic panel 205 structuring the ceramic layers 21A to split into a plurality of the ceramic layers 21A; and separate the ceramic panel 205 into a plurality of (with sixteen) first ceramic layer-forming areas 203 (the step of forming scribe line S11). FIG. 14A is a plan view of the ceramic panel 205 disposed so that one surface of the ceramic panel 205 on which the first wiring layers 11A and 12A are formed faces up: FIG. 14B shows a plan view of the ceramic panel 205 disposed so that the other surface of the ceramic panel 205 on which the first heat-transmission metal layers 31A are formed faces up.

On the one surface of the ceramic panel 205, as shown in FIG. 14A, scribe lines 202b are formed in non-joined parts excluding planned-joining areas of the first wiring layers 11A and 12A so as to go through between the planned-joining areas of the first wiring layers 11A and 12A. Specifically, two scribe lines 202b formed of straight lines penetrating sides facing to each other in a crosswise direction of the ceramic panel 205 are formed.

On the other hand, on the other surface of the ceramic panel 205, as shown in FIG. 14B, the scribe line 202a and 202b are formed in non-joined parts excluding planned-joining areas of the first heat-transmission metal layers 31A so as to go through between the planned-joining areas of the first heat-transmission metal layers 31A. Specifically, three scribe lines 202a formed from straight lines penetrating sides facing to each other in a vertical direction of the ceramic panel 205 and one 202b formed from a straight line penetrating sides facing to each other in the crosswise direction of the ceramic panel 205 are formed.

As described above, by forming the scribe line 202a and 202b of the one surface and the other surface of the ceramic panel 205, the three scribe lines 202 are formed with an equal interval in the vertical direction on the ceramic panel 205, and the three scribe lines 202b can be formed with an equal interval in the crosswise direction, so that the scribe line 202a and 202b are formed with three in vertical and crosswise respectively. By these six scribe lines 202a and 202b, the first ceramic layer-forming areas 203 with sixteen which are separated into a size of an outer shape of the ceramic layers 21A are formed being disposed with four in the vertical and crosswise directions respectively.

In addition, the scribe line 202a and 202b can be formed on the non-joined parts of the first wiring layers 11A and 12A and the first heat-transmission metal layers 31A, and can be formed also on the joined parts of the first wiring layer 11A and the joined parts 31A, so as to be formed on both surfaces of the ceramic panel 205.

### (Step of Forming Metal Layer)

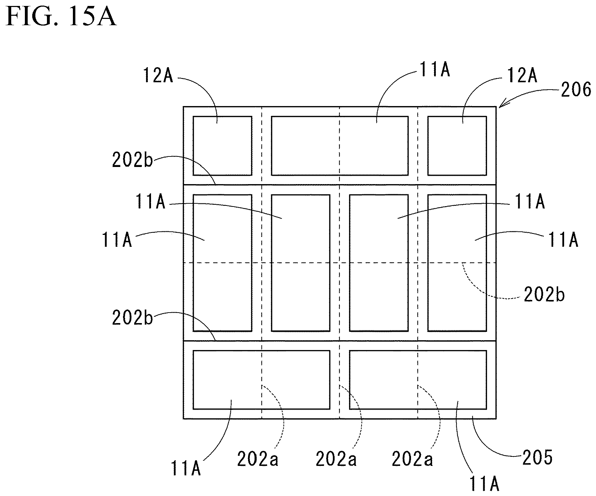

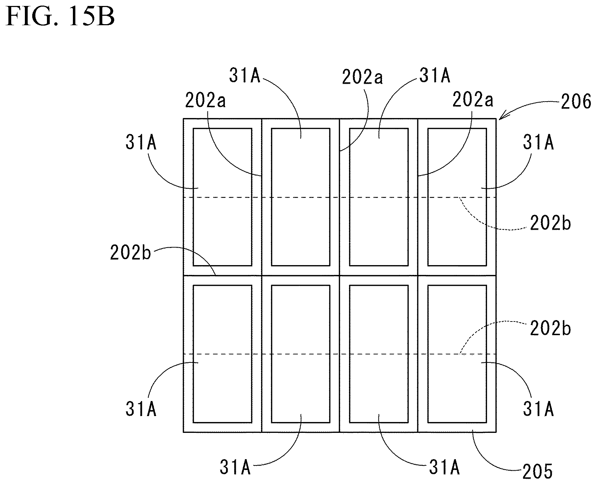

After the step of forming scribe line S11, the first wiring layers 11A and 12A are formed on one surface of the ceramic panel 205 as shown in FIG. 15A; the first heat-transmission metal layers 31A are formed on the other surface of the ceramic panel 205 as shown in FIG. 15B, so that formed is a bundle body 206 in which the first wiring layers 11A and 12A and the first heat-transmission metal layers 31A are joined on both the surfaces of the ceramic panel 205 (a step of forming metal layer S12).

Although a detailed explanation will be omitted: by joining metal boards which will be the first wiring layers 11A and 12A on one surface of the ceramic panel 205, joining metal boards which will be 31A on the other surface of the ceramic panel 205, and then performing etching; the first wiring layers 11A and 12A are patterned on the one surface of the ceramic panel 205, and the first heat-transmission metal layers 31A are patterned on the other surface of the ceramic panel 205. At this time, since the scribe line 202a and 202b are formed on the non-joined parts excluding the planned-joining areas of the first wiring layers 11A and 11B and the non-joined parts excluding the planned-joining areas of the first heat-transmission metal layers 31A: the whole of the scribe line 202a and 202b can be exposed by removing metal-layer parts (the metal boards) formed by layering on the scribe line 202a and 202b.

In addition, it is possible to form the first wiring layers 11A and 12A and the first heat-transmission metal layers 31A without performing etching, but by joining metal boards which are patterned in advance on the ceramic panel 205. Moreover, the first wiring layers 11A and 12A can be structured from a sintered body of silver (Ag).

### (Step of Splitting)

After the step of forming metal layer S12, by bending the ceramic panel 205 so as to swell at the side on which the scribe line 202a and 202b are formed, the ceramic panel 205 of the bundle body 206 is split along the scribe line 202a and 202b, so that the first ceramic layer-forming areas 203 are divided into pieces of the individual 21A. Accordingly, the first wiring board 5A in which the first wiring layers 11A and 12A, the ceramic layers 21A, and the first heat-transmission metal layers 31A are joined is formed (a step of splitting S13).

Since the scribe line 202a and 202b are formed on a side opposite to a joined surface of the first wiring layer 11A or the first heat-transmission metal layers 31A, it is easy to split the ceramic panel 205 along the scribe line 202a and 202b. Moreover, since the scribe line 202a and 202b are formed from simple straight lines penetrating the sides facing to each other of the ceramic panel 205, it is possible to smoothly split the ceramic panel 205 along the scribe line 202a and 202b. In addition, the second wiring board 5B is manufactured by the same process as in the first wiring board 5A.

The first wiring board 5A formed as above described has the first wiring layers 11A and 12A: however, between the first wiring layers 11A and 11A or between the first wiring layers 11A and 12A is connected by the first heat-transmission metal layers 31A. Moreover, since the ceramic layers 21A which are divided into pieces are connected by the first wiring layer 11A or the first heat-transmission metal layers 31A, the first wiring layers 11A and 12A, the ceramic layers 21A, and the first heat-transmission metal layers 31A can be treated integrally in the first wiring board 5A. Moreover, also in the second wiring board 5B structured as in the first wiring board 5A, the second wiring layers 11B, the second ceramic layers 21B, and the second heat-transmission metal layers 31B and 32B can be treated integrally.

### (Step of Joining)

Next, one end surface of the P-type thermoelectric conversion element 3 and one end surface of the N-type thermoelectric conversion element 4 are joined on the first wiring layer 11A of the one first wiring board 5A; and the other end surface of the P-type thermoelectric conversion element 3 and the other end surface of the N-type thermoelectric conversion element 4 are joined on the second wiring layers 11B of the other second wiring board 5B (a step of joining S14). Accordingly, as shown in FIG. 9, the thermoelectric conversion module 103 is manufactured in which the P-type thermoelectric conversion element 3 and the N-type thermoelectric conversion element 4 are alternately connected in series between the first wiring board 5A and 5B.

Specifically, the first wiring layers 11A and 11B are joined to the P-type thermoelectric conversion element 3 and the N-type thermoelectric conversion element 4 by bonding paste or brazing material, or solid-phase diffusion bonding by adding load, or the like. Then, as in the thermoelectric conversion module 101 of the first embodiment shown in FIG. 5 to FIG. 7, the thermoelectric conversion elements 3 and 4 and the first wiring layers 11A and 11B are closely in contact with each other and evenly pressurized between the pressurizing boards 401A and 401B.

Illustration will be omitted though, in this step of joining S14, it is possible to perform with using the complement members or layering and arranging an even number of the bundle bodies in the layering direction. Accordingly, when joining the first wiring layers 11A and 11B to the P-type thermoelectric conversion element 3 and the N-type thermoelectric conversion element 4, it is possible to evenly pressurize the thermoelectric conversion elements 3 and 4 and the first wiring layers 11A and 11B respectively with being in closely contact. Moreover, in a case in which an even number of the bundle bodies are layered and arranged in the layering direction, by disposing the graphite sheets having cushion property between the bundle bodies, inclinations can be corrected respectively at the arranged parts of the thermoelectric conversion elements 3 and 4 in a surface direction of the first wiring board 5A and 5B: it is possible to pressurize the thermoelectric conversion elements 3 and 4 to the first wiring board 5A and 5B more evenly.

In addition, as described above, even though the first wiring board 5A has the first wiring layers 11A and 12A, the first wiring layers 11A and 12A can be treated integrally since the first wiring layers 11A and 12A are connected by the first heat-transmission metal layers 31A, so that the first wiring board 5A can be easily treated. Similarly, even though the second wiring board 5B has the second wiring layers 11B, the second wiring layers 11B can be treated integrally since the second wiring layers 11B are connected by the second heat-transmission metal layers 31B, so that the second wiring board 5B can be easily treated.

Moreover, as in the manufacturing method of the third embodiment, after forming the first wiring layers 11A and 12A and the first heat-transmission metal layers 31A on the large ceramic panel 205, the ceramic panel 205 is split along the scribe line 202a and 202b; thereby enabling to easily form 5A having the first wiring layers 11A and 12A which are arranged with a prescribed pattern and 21A which are divide into pieces. Then, by using the first wiring board 5A, it is easy to manufacture the large thermoelectric conversion module 103 on which a large number of the thermoelectric conversion elements 3 and 4 are joined (mounted).

Moreover, also in the thermoelectric conversion module 103 of the third embodiment manufactured as above, the ceramic layers 21A structuring the first wiring board 5A are formed independently on the respective thermoelectric conversion elements 3 and 4; and the connections between the P-type thermoelectric conversion element 3 and the N-type thermoelectric conversion element 4 on the rigid first ceramic layers 21A are interrupted. Also regarding the second wiring board 5B which is arranged opposing to the first wiring board 5A, the second ceramic layers 21B are formed independently on the respective thermoelectric conversion elements 3 and 4; and the connections between the P-type thermoelectric conversion element 3 and the N-type thermoelectric conversion element 4 on the rigid 21B are interrupted. Accordingly, the ceramic layers 21A and 21B do not restrain deformation of the thermoelectric conversion elements 3 and 4 resulting from thermal expansion.

Moreover, the ceramic layers 21A are connected only by the first wiring layer 11A or the first heat-transmission metal layers 31A; and the second ceramic layers 21B are connected only by the second wiring layers 11B or the second heat-transmission metal layers 31B. Accordingly, regarding the difference of thermal expansion between the adjacent thermoelectric conversion elements P-type 3 and the thermoelectric conversion elements N-type 4, the dimension change thereof can be absorbed by deformations of the first wiring layer 11A connecting the thermoelectric conversion elements 3 and 4 or the connecting part of the first heat-transmission metal layers 31A, and the connecting part of the second wiring layers 11B or the second heat-transmission metal layers 31B. Therefore, it is possible to reduce the thermal stress generated in the thermoelectric conversion elements 3 and 4 by the difference of thermal expansion. Moreover, it is possible to prevent the thermoelectric conversion elements 3 and 4 from being peeled off from the first wiring board 5A and 5B (the first wiring layers 11A and 12A and the second wiring layers 11B) or from cracking. Accordingly, it is possible to favorably maintain the electrical connection between the thermoelectric conversion elements 3 and 4 connected by the first wiring layers 11A and 12A and the second wiring layers 11B, so that it is possible to favorably maintain joining reliability, thermal conductivity, and electrical conductivity of the thermoelectric conversion module 103.

Moreover, since the ceramic layers 21A or the second ceramic layers 21B which are the insulation boards are provided on the first wiring board 5A and 5B, it is possible to prevent the first wiring layers 11A and 12A or the second wiring layers 11B from being contact with the heat source or the like owing to the ceramic layers 21A or the second ceramic layers 21B when the thermoelectric conversion module 103 is installed on the heat source or the like. Accordingly, it is possible to reliably prevent the electric leak of the heat source or the like and the first wiring layers 11A and 12A or the second wiring layers 11B, so the insulation state can be favorably maintained.

Moreover, since the first wiring board 5A and 5B is provided with the heat-transmission metal layers 31A or 31B and 32B, it is possible to improve the adhesiveness of the heat source or the like and the thermoelectric conversion module 103 by the heat-transmission metal layers 31A, 31B and 32B, so that the thermal conductivity can be improved. Accordingly, it is possible to improve the thermoelectric conversion performance (the power generation efficiency) of the thermoelectric conversion module 103.

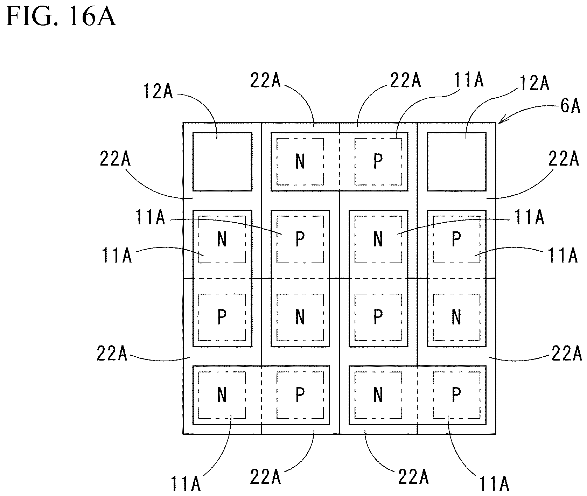

In the thermoelectric conversion modules 101, 102 and 103 of the above embodiments, the first wiring boards 2A and 5A and the second wiring boards 2B and 5B are structured to have the plurality of the first ceramic layers 2A or the second ceramic layers 21B formed independently on the respective thermoelectric conversion elements 3 and 4: however, it may be structured to be separated into the plurality of the thermoelectric conversion elements 3 and 4 and have first ceramic layers 22A to 22C which are separated between any of the P-type thermoelectric conversion elements 3 and the N-type thermoelectric conversion elements 4, as in first wiring boards 6A to 6C shown in FIG. 16A to FIG. 18B.

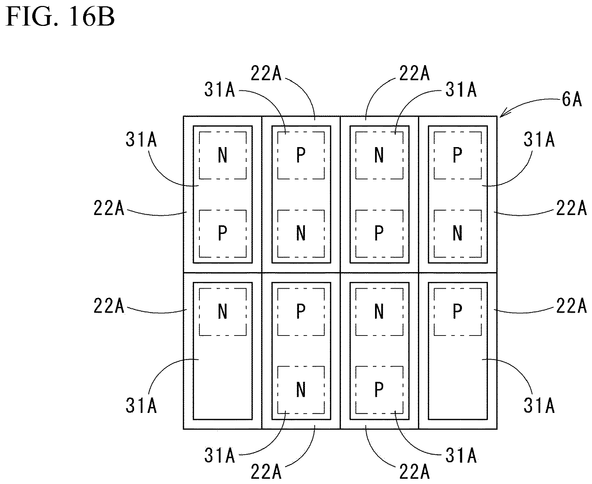

For example, the first wiring board 6A shown in FIG. 16A and FIG. 16B has a pattern in consisting of the first wiring boards 11A and 12A and the first heat-transmission metal layer 31A, as in the first wiring board 5A in the thermoelectric conversion module 103 of the second embodiment. However, the first ceramic layers 22A are separated to have the thermoelectric conversion elements 3 and 4 respectively which are adjacent one pair (two pieces): so that it is structured from the first ceramic layers 22A with eight in total. As shown in FIG. 16A, the respective first ceramic layers 22A and 22a are connected by the first wiring layers 11A, so that the plurality of first ceramic layers 22A structuring the first wiring board 6A are integrally provided. Moreover, the first wiring layers 11A of the first wiring board 6A is formed with connecting one pair of the P-type thermoelectric conversion element 3 and the N-type thermoelectric conversion element 4, and formed with spanning the first ceramic layers 22A and 22A of the thermoelectric conversion elements 3 and 4.

Also in the thermoelectric conversion module using the first wiring board 6A structured as above, the rigid first ceramic layers 22A are divided between any of the P-type thermoelectric conversion elements 3 and the N-type thermoelectric conversion elements 4 and plurally provided. Accordingly, between these P-type thermoelectric conversion elements 3 and the N-type thermoelectric conversion elements 4, deformation owing to the thermal expansion of the P-type thermoelectric conversion elements 3 and the N-type thermoelectric conversion elements 4 is not restricted by the first ceramic layers 22A which are joined to the others respectively. Moreover, a difference of thermal expansion between the P-type thermoelectric conversion elements 3 and the N-type thermoelectric conversion elements 4 at the separate parts of the first ceramic layers 22A can be absorbed at dimension change by deformation of connecting parts of the first wiring layers 11A connecting the thermoelectric conversion elements 3 and 4. Accordingly, it is possible to prevent thermal stress from generating generated in the thermoelectric conversion elements 3 and 4 resulting from the difference of thermal expansion of the thermoelectric conversion elements 3 and 4.

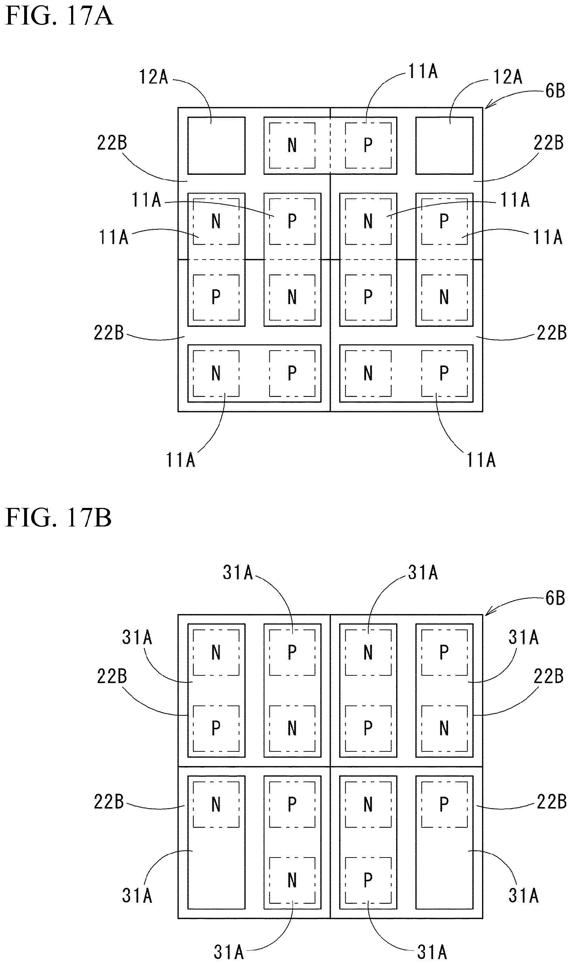

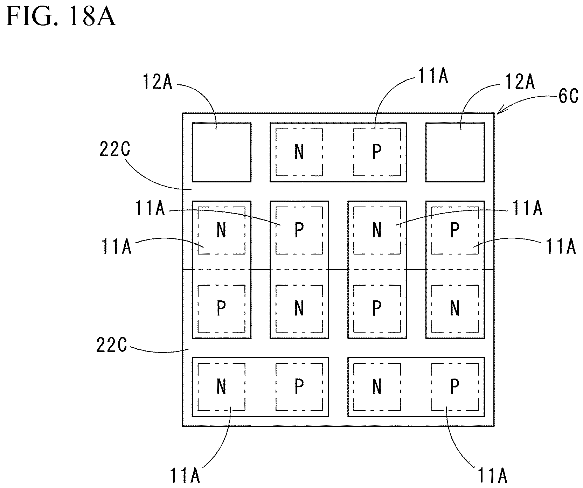

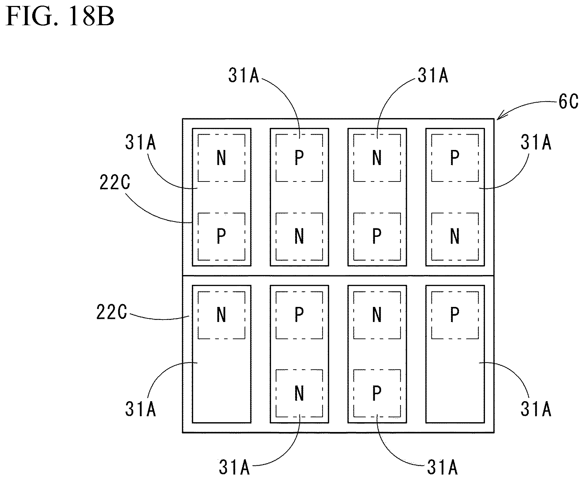

In addition, the number of the first ceramic layers can be reduced than that of the first wiring board 6A shown in FIG. 16A and FIG. 16B. For example, first ceramic layers 22B of a first wiring board 6B shown in FIG. 17A and FIG. 17B are separated for the four thermoelectric conversion elements 3 and 4 respectively; it is structured from the first ceramic layers 22B with four in total. Moreover, the first ceramic layers 22C of the first wiring board 6C shown in FIG. 18A and FIG. 18B are separated for the respective thermoelectric conversion elements 3 and 4 with eight and structured from the first ceramic layers 22C with two in total.

As described above, since the first ceramic layers 22B and 22C which are plurally provided are provided with being divided between any of the P-type thermoelectric conversion elements 3 and the N-type thermoelectric conversion elements 4, between the P-type thermoelectric conversion elements 3 and the N-type thermoelectric conversion elements 4, deformation with the thermal expansion of the P-type thermoelectric conversion element 3 and the N-type thermoelectric conversion elements 4 is not restricted by the first ceramic layers 22B and 22C which are joined to the other members respectively. Moreover, a difference of thermal expansion of the P-type thermoelectric conversion elements 3 and the N-type thermoelectric conversion elements 4 at separate parts of the first ceramic layers 22B and 22C can be absorbed at a dimension change by deformation at connecting parts of the first wiring layers 11A connecting the thermoelectric conversion elements 3 and 4. Accordingly, it is possible to prevent thermal stress from generating generated in the thermoelectric conversion elements 3 and 4 by the difference of thermal expansion of the thermoelectric conversion elements 3 and 4.

Therefore, also in thermoelectric conversion modules using the large first wiring boards 6A to 6C having the plurality of wiring layers 11A, it is possible to prevent the thermal stress from generating generated in the thermoelectric conversion elements 3 and 4 by the difference of thermal expansion of the thermoelectric conversion elements 3 and 4. Accordingly, it is possible to prevent the thermoelectric conversion elements 3 and 4 from peeling off from the first wiring boards 6A to 6C (the first wiring layers 11A) or the thermoelectric conversion elements 3 and 4 from cracking. Therefore, it is possible to favorably maintain electrical connection between the thermoelectric conversion elements 3 and 4 connected by the first wiring layer 11A, and it is possible to favorably maintain the joining reliability, the thermal conductivity and the electrical conductivity of the thermoelectric conversion modules.

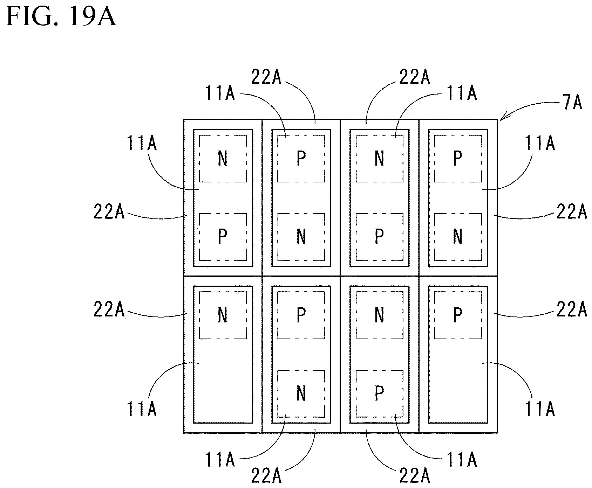

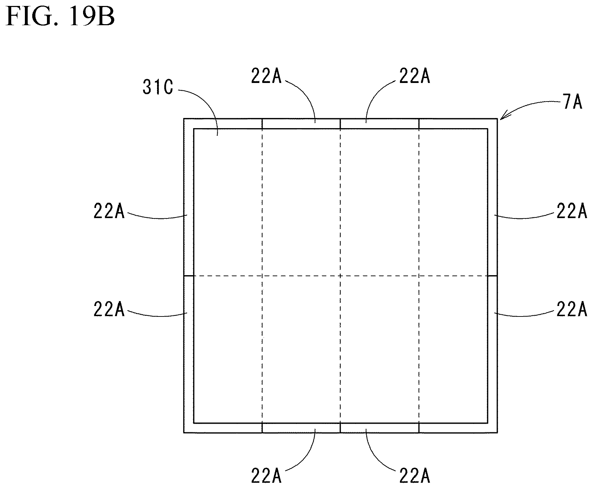

In addition, in the first wiring boards 2A, 5A and 6A to 6C of the above embodiments, the structures have the first heat-transmission metal layers 31A and 32A which are separated into a plurality of patterns respectively: however, as in a first wiring board 7A shown in FIG. 19A and FIG. 19B, a first wiring layer 31C can be structured as a large size connecting the first ceramic layers 22A with three or more. In this case, since the first ceramic layers 22A can be connected by the first heat-transmission metal layer 31C, the first wiring board 7A can be integrally structured without connecting the first ceramic layers 22A by the first wiring layers 11A.

Also in a thermoelectric conversion module using the first wiring board 7A shown in FIG. 19A and FIG. 19B, by providing the first ceramic layers 22A which are plurally provided with being divided between any of the P-type thermoelectric conversion elements 3 and the N-type thermoelectric conversion elements 4, these P-type 3 and the N-type thermoelectric conversion elements 4 are not restricted in deformation owing to thermal expansion of the P-type thermoelectric conversion elements 3 and the N-type thermoelectric conversion elements 4 by the first ceramic layers 22A which are joined to the other members respectively. Moreover, a difference of thermal expansion between the P-type thermoelectric conversion elements 3 and N-type 4 at separate parts of the first ceramic layers 22A can be absorbed in a dimension change by deformation of connecting parts of the first heat-transmission metal layer 31C connecting between the thermoelectric conversion elements 3 and 4. Accordingly, thermal stress generated in the thermoelectric conversion elements 3 and 4 by the difference of thermal expansion between the thermoelectric conversion elements 3 and 4 can be prevented.

In addition, in the above-described embodiments, the second wiring layers, the second ceramic layers and the second heat-transmission metal layers can be structured as that of the first wiring layers, the first ceramic layers and the first heat-transmission metal layers.

The present invention is not limited to the above-described embodiments and various modifications may be made without departing from the scope of the present invention.

### Industrial Applicability

Destruction owing to the difference of thermal expansion of the thermoelectric conversion elements can be prevented, and it is possible to provide the thermoelectric conversion module having the excellent joining reliability, the thermal conductivity and the electrical conductivity.

### Reference Signs List

- 2A, 5A, 6A, 6B, 6C, 7A: First wiring board
- 2B, 5B: Second wiring board
- 3: P-type thermoelectric conversion element (Thermoelectric conversion element)
- 4: N-type thermoelectric conversion element (Thermoelectric conversion element)
- 11A, 12A: First wiring layer
- 11B, 12B: Second wiring layer
- 21A, 22A, 22B, 22C: First ceramic layer
- 21B: Second ceramic layer
- 31A, 32A, 31C: First heat-transmission metal layer
- 31B, 32B: Second heat-transmission metal layer
- 41: Metalized layer
- 91: Wiring
- 201, 205: Ceramic material
- 202, 202a, 202b: Scribe line
- 203: First ceramic layer-forming area
- 204, 206: Layered body
- 301,302: Metal board
- 401A, 401B: Pressurizing board
- 405: Bundle body
- 411,412,413: Complement member
- 420: Graphite sheet
- 101, 102, 103: Thermoelectric conversion module

## Claims

1. A thermoelectric conversion module comprising:
multiple thermoelectric conversion elements consisting of P-type thermoelectric conversion elements and N-type thermoelectric conversion elements which are different in coefficient of linear expansion; and
a first wiring board disposed at one end side of the multiple thermoelectric conversion elements, wherein
the first wiring board comprises: first wiring layers on which the P-type thermoelectric conversion elements and the N-type thermoelectric conversion elements which are adjacent are joined; and first ceramic layers which are plurally separated and joined on surfaces of the first wiring layers opposite to surfaces on which the P-type thermoelectric conversion elements and the N-type thermoelectric conversion elements are joined, wherein
the first ceramic layers are separated between any one of the P-type thermoelectric conversion elements and any one of the N-type thermoelectric conversion elements.

2. The thermoelectric conversion module according to claim 1, wherein the first wiring layers are formed with spanning the first ceramic layers.

3. The thermoelectric conversion module according to claim 1, wherein the first ceramic layers are formed independently on the every thermoelectric conversion element.

4. The thermoelectric conversion module according to claim 1, wherein
the first wiring board comprises a plurality of the first wiring layers and first heat-transmission metal layers joined on surfaces of the first ceramic layers opposite to surfaces on which the first wiring layers are joined, and wherein
the first heat-transmission metal layers are formed with spanning the adjacent two first wiring layers and formed with spanning the adjacent two first ceramic layers.

5. The thermoelectric conversion module according to claim 1, further comprising a second wiring board disposed at the other end side of the thermoelectric conversion elements, wherein
the P-type thermoelectric conversion elements and the N-type thermoelectric conversion elements are electrically connected in series via the first wiring board and the second wiring board which are disposed with facing to each other.

6. The thermoelectric conversion module according to claim 5, wherein
the second wiring board comprises second wiring layers on which the P-type thermoelectric conversion elements and the N-type thermoelectric conversion elements which are adjacent are joined; and second ceramic layers which are plurally separated and joined on surfaces of the second wiring layers opposite to surfaces on which the P-type thermoelectric conversion elements and the N-type thermoelectric conversion elements are joined, and wherein
the second ceramic layers are separated between any one of the P-type thermoelectric conversion elements and any one of the N-type thermoelectric conversion elements.

7. A method of manufacturing thermoelectric conversion module comprising:
a step of forming a scribe line on a ceramic panel for splitting the ceramic panel into multiple first ceramic layers;
a step of forming a metal layer after the step of forming the scribe line, forming first wiring layers on one surface of the ceramic panel with spanning adjacent two first ceramic layer-forming areas among the multiple first ceramic layer-forming areas which are divided by the scribe line;
a step of splitting after the step of forming the metal layer, forming a first wiring board on which the first wiring layer and the first ceramic layers are joined by splitting the ceramic panel on which the first wiring layer is formed along the scribe line; and
a step of joining after the step of splitting, manufacturing a thermoelectric conversion module in which a P-type thermoelectric conversion element and an N-type thermoelectric conversion element are connected in series, by joining the P-type thermoelectric conversion element and the N-type thermoelectric conversion element which are different in coefficient of linear expansion on a surface of the first wiring layer opposite to a surface on which the first ceramic layers are joined.

8. The method of manufacturing the thermoelectric conversion module according to claim 7, wherein
the step of joining is a step of joining the P-type thermoelectric conversion element and the N-type thermoelectric conversion element on the first wiring layers by disposing a bundle body in which the P-type thermoelectric conversion element and the N-type thermoelectric conversion element are layered and the first wiring layers of the first wiring board between one pair of pressurizing boards which are disposed with facing to each other, and heating the bundle body in a pressurized state in the layering direction,
in the step of joining,
a complement member is disposed at least between the pressurizing boards and the one thermoelectric conversion element which has smaller coefficient of linear expansion between the P-type thermoelectric conversion element and the N-type thermoelectric conversion element, and
when joining the first wiring layers to the P-type thermoelectric conversion element and the N-type thermoelectric conversion element, a difference between a height of the one thermoelectric conversion element and the complement member and a height of the other thermoelectric conversion element and the complement member is made smaller than a difference between a height of the one thermoelectric conversion element and a height of the other thermoelectric conversion element.

9. The method of manufacturing the thermoelectric conversion module according to claim 7, wherein
the step of joining is a step of joining the P-type thermoelectric conversion element and the N-type thermoelectric conversion element on the first wiring layers, by disposing bundle bodies in which the P-type thermoelectric conversion element and the N-type thermoelectric conversion element are layered on the first wiring layers of the first wiring board are disposed between one pair of pressurizing boards with facing to each other, and heating the bundle body in a pressurized state in the layering direction,
in the step of joining,
the bundle bodies are arranged with even-numbers with being layered in the layering direction, and same number of the P-type thermoelectric conversion elements and the N-type thermoelectric conversion elements are arranged in the layering direction.

10. The method of manufacturing the thermoelectric conversion module according to claim 7, wherein
the step of forming metal layer is a step of:
forming the first wiring layers on the one surface of the ceramic panel; and
forming the first heat-transmission metal layer on the other surface of the ceramic panel, and
in the step of forming metal layer,
the first heat-transmission metal layer is formed with spanning the adjacent two first wiring layers and formed with spanning the adjacent two first ceramic layer-forming areas.

11. The method of manufacturing the thermoelectric conversion module according to claim 7, wherein
in the step of forming scribe line,
the scribe line is formed in a non-joined part on one surface of the ceramic panel excluding a planned-joining area of the first wiring layers.

12. The method of manufacturing the thermoelectric conversion module according to claim 10, wherein
in the step of forming scribe line,
the scribe line is formed in a non-joining part on the other surface of the ceramic panel excluding a planned-joining area of the first heat-transmission metal layer.

13. The method of manufacturing the thermoelectric conversion module according to claim 7, wherein
in the step of forming scribe line,
the scribe line is formed by a straight line penetrating sides of the ceramic panel which face to each other.
